# EUROPEAN PATENT APPLICATION

(11) **EP 2 243 796 A1**
(43) Date of publication of application: **27.10.2010**
(21) Application number: 09711231.2
(22) Date of filing: 09.02.2009
(51) Int. Cl.: C08G 61/12, H01L 29/786, H01L 51/05, H01L 51/30, H01L 51/40, H01L 51/42

(54) **POLYMER, ORGANIC THIN FILM USING THE SAME, AND ORGANIC THIN FILM DEVICE**

(30) Priority: 13.02.2008 JP 2008032021
(71) Applicant: Osaka University, Suita-shi Osaka 565-0871 (JP); Sumitomo Chemical Company, Limited, Tokyo 104-8260 (JP)
(72) Inventor: KARAKAWA, Makoto, Suita-shi Osaka 565-0871 (JP); ASO, Yoshio, Suita-shi Osaka 565-0871 (JP); UEDA, Masato, Tsukuba-shi Ibaraki 305-0046 (JP)
(74) Representative: Vossius & Partner
(86) International application number: PCT/JP2009/052156
(87) International publication number: WO 2009/101914

(57) **Abstract**

A polymer according to the present invention comprises a repeating structure represented by the following formula (1), wherein L and X each independently have a configuration in which are linked a plurality of conjugation forming structures each conjugated by itself, and each have at least one thienylene structure as the conjugation forming structure: 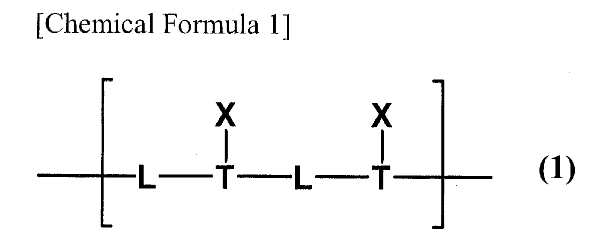 wherein each X represents a monovalent organic group that may have a substituent, each L represents a divalent organic group that may have a substituent, and each T represents a trivalent organic group that may have a substituent, with the proviso that in the formula, the X's represent the same group, the L's represent the same group, and the T's represent the same group.

## Description

### Technical Field

The present invention relates to a polymer, an organic film using the same, and an organic film device.

### Background Art

Thin films containing an organic material having charge (electron or hole) transport property is expected to be applied to organic film devices such as organic film transistors, organic solar cells, and photosensors, and development of organic p-type semiconductors (exhibiting hole transport property) and organic n-type semiconductors (exhibiting electron transport property) has been considered in various ways.

As an organic p-type semiconductor material, compounds having a thiophene ring such as oligothiophene and polythiophene are expected to show high hole transport property because the compound can take a stable radical cationic state. Particularly, oligothiophene having a long chain length has a long conjugation length, and is expected to transport holes more effectively. However, a linear molecule thereof has poor regularity of molecular arrangement in a solid state, and therefore the intermolecular interaction thereof is not sufficient so that the potential of oligothiophene cannot be sufficiently used yet.

On the other hand, compounds having a hyperbranched structure, i.e., the so-called dendrimers and hyperbranch polymers attract attention. Unlike linear compounds, the dendrimers and hyperbranch polymers have characteristics such that a viscosity thereof can be reduced, solubility in an organic solvent is good, and function can be manifested by introduction of a functional group. Various oligothiophenes having a branched structure are also reported (see Patent Document 1).
[Patent Document 1] Japanese Patent No. 3074277

### Disclosure of the Invention

### Problems to be Solved by the Invention

From the viewpoint of practical use of the organic film device using such an organic semiconductor material, however, not only high charge transport property but also inexpensive production by application are demanded. For uniform film formation by application, the solubility of the organic semiconductor material in the organic solvent is important. However, it is yet hard to say that the known materials mentioned above have sufficient performance.

Then, an object of the present invention is to provide a polymer that has high charge transport property and solubility in a solvent, can be formed into an approximately uniform thin film, and can be used as an organic p-type semiconductor. An object of the present invention is also to provide an organic film containing this polymer and an organic film device comprising the organic film.

### Means for Solving the Problems

To achieve the above-mentioned objects, the present invention provides a polymer comprising a repeating structure represented by the following formula (1), wherein L and X each independently have a configuration in which are linked a plurality of conjugation forming structures each conjugated by itself, and each have at least one thienylene structure as the above-mentioned conjugation forming structure.

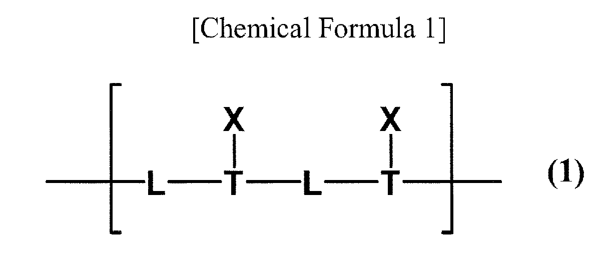

In the formula (1), each X represents a monovalent organic group that may have a substituent, each L represents a divalent organic group that may have a substituent, and each T represents a trivalent organic group that may have a substituent. However, in the formula, the X's represent the same group, the L's represent the same group, and the T's represent the same group.

The polymer according to the present invention can be used as an organic semiconductor having high charge transport property because at least each L or each X includes the thiophene ring structure so that conjugate planarity of a ring is good, and an interaction between molecules can be strengthened. In addition to these, the polymer according to the present invention has high solubility in a solvent, and therefore an organic film device having excellent performance can be produced by forming an approximately uniform thin film using a solution.

In the polymer according to the present invention, a structure in which the X's, the L's, and the T's are in conjugation as a whole is preferably formed. By forming such a structure (a branched conjugate structure), the planarity is enhanced as the entire molecule, conjugate properties are enhanced, and the charge transport property when the polymer is used as an organic semiconductor is significantly high.

In the polymer according to the present invention, each L is preferably a divalent organic group represented by the following formula (2).

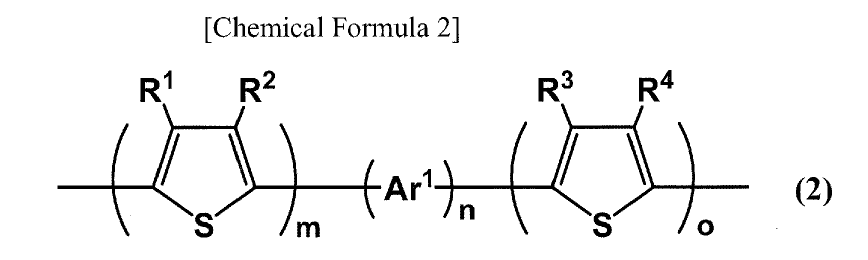

In the formula (2), Ar¹ represents a divalent aromatic hydrocarbon group that may have a substituent or a divalent heterocyclic group that may have a substituent. R¹, R², R³, and R⁴ each independently represent a hydrogen atom, an alkyl group, an alkoxy group, an aryl group that may have a substituent, or a monovalent heterocyclic group that may have a substituent, and part or all of hydrogen atoms in each of these groups may be replaced by a fluorine atom. When there are a plurality of R¹'s, a plurality of R²'s, a plurality of R³'s, and a plurality of R⁴'s, the R¹'s may be the same as or different from each other, the R²'s may be the same as or different from each other, the R³'s may be the same as or different from each other, and the R⁴'s may be the same as or different from each other. Moreover, m, n, and o each independently represent an integer of 0 to 10. However, at least one of m and o is an integer of not less than one, and m + n + o is an integer of 2 to 20.

The polymer having such a structure has good conjugate properties, and also has particularly high stability of the compound. Accordingly, the polymer has much better charge transport property and exerts excellent properties when used as an organic p-type semiconductor.

In the polymer according to the present invention, each T is preferably one of trivalent organic groups represented by the following formulas (3) to (7), and particularly preferably a trivalent organic group represented by the following formula (4').

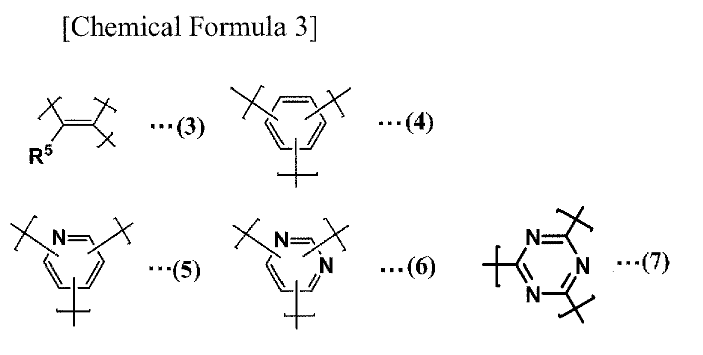

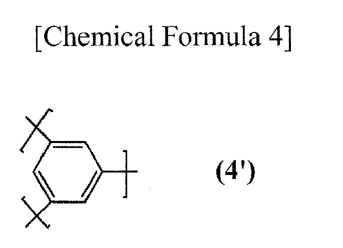

In the formula (3), R⁵ represents a hydrogen atom, an alkyl group, an alkoxy group, an aryl group, or a cyano group.

Moreover, in the polymer according to the present invention, each X is particularly preferably a monovalent organic group represented by the following formula (8).

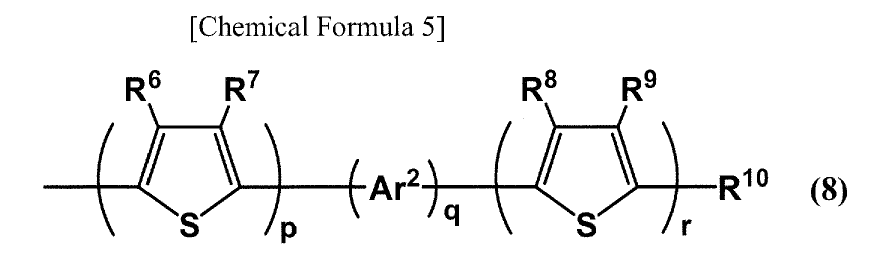

In the formula (8), Ar² represents a divalent aromatic hydrocarbon group that may have a substituent or a divalent heterocyclic group that may have a substituent. R⁶, R⁷, R⁸, and R⁹ each independently represent a hydrogen atom, an alkyl group, an alkoxy group, an aryl group that may have a substituent, or a monovalent heterocyclic group that may have a substituent, and part or all of hydrogen atoms in each of these groups may be replaced by a fluorine atom. When there are a plurality of R⁶'s, a plurality of R⁷'s, a plurality of R⁸'s, and a plurality of R⁹'s, the R⁶'s may be the same as or different from each other, the R⁷'s may be the same as or different from each other, the R⁸'s may be the same as or different from each other, and the R⁹'s may be the same as or different from each other. R¹⁰ represents a hydrogen atom or a monovalent group that may have a substituent. Moreover, p, q, and r each independently represent an integer of 0 to 10. However, at least one of p and r is an integer of not less than one, and p + q + r is an integer of 2 to 20.

The polymer formed of the structure as mentioned above has much higher conjugate properties, and can be used as an organic p-type semiconductor having much higher charge transport property and stability. Particularly, in the case where each L is a divalent organic group represented by the formula (2), the uniformity as the entire molecule is excellent, the conjugate properties as the entire molecule are enhanced, and the charge transport property when the polymer is used as an organic semiconductor is significantly improved.

In the polymer according to the present invention, the repeating structure represented by the above formula (1) is preferably a repeating structure represented by the following formula (9).

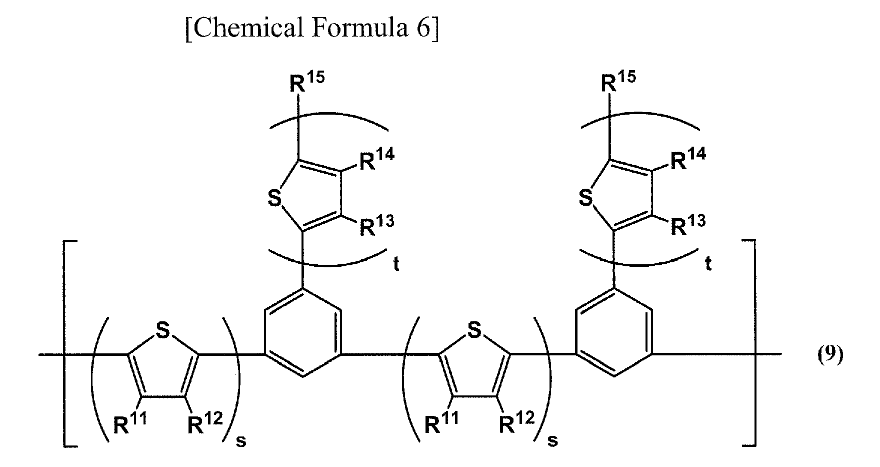

In the formula (9), R¹¹, R¹², R¹³, and R¹⁴ each independently represent a hydrogen atom, an alkyl group, an alkoxy group, an aryl group that may have a substituent, or a monovalent heterocyclic group that may have a substituent, and part or all of hydrogen atoms in each of these groups may be replaced by a fluorine atom. Because s and/or t are not less than two, when there are a plurality of R¹¹'s, a plurality of R¹²'s, a plurality of R¹³'s, and a plurality of R¹⁴'s, the R¹¹'s may be the same as or different from each other, the R¹²'s may be the same as or different from each other, the R¹³'s may be the same as or different from each other, and the R¹⁴'s may be the same as or different from each other. R¹⁵ represents a hydrogen atom or a monovalent group that may have a substituent. s and t each independently represent an integer of 2 to 12. However, in the formula (9), the R¹¹'s represent the same group, the R¹²'s represent the same group, the R¹³'s represent the same group, the R¹⁴'s represent the same group, and the R¹⁵'s represent the same group. Moreover, in the formula (9), s's represent the same integer, and t's represent the same integer, respectively.

The polymer having the repeating structure represented by the above formula (9) has much higher conjugate properties because of its excellent uniformity, and can be used as an organic p-type semiconductor having much higher charge transport property and stability.

The polymer according to the present invention preferably has at least one repeating structures represented by the above formula (1) and at least one repeating structures represented by the following formula (10).

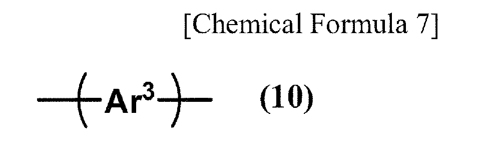

In the formula (10), Ar³ represents a divalent aromatic hydrocarbon group that may have a substituent or a divalent heterocyclic group that may have a substituent.

The polymer having the structure mentioned above is preferable because ranges where solubility and mechanical, thermal or electronic properties may be changed are wider.

The present invention also provides an organic film containing the polymer according to the present invention. The present invention further provides an organic film device, an organic film transistor, an organic solar cell, and a photosensor comprising the organic film.

Such an organic film, organic film transistor, organic solar cell, and photosensor are formed using the polymer according to the present invention that shows high charge transport property as mentioned above, and therefore excellent performance can be obtained.

### Effect of the Invention

According to the present invention, a novel polymer that has high charge transport property and solubility in a solvent, can be formed into an approximately uniform thin film, and can be used as an organic p-type semiconductor can be provided. According to the present invention, an organic film containing this polymer and an organic film device comprising this organic film can also be provided.

### Brief Description of the Drawings

Figure 1 is a schematic sectional view of an organic film transistor according to a first embodiment;
Figure 2 is a schematic sectional view of an organic film transistor according to a second embodiment;
Figure 3 is a schematic sectional view of an organic film transistor according to a third embodiment;
Figure 4 is a schematic sectional view of an organic film transistor according to a fourth embodiment;
Figure 5 is a schematic sectional view of an organic film transistor according to a fifth embodiment;
Figure 6 is a schematic sectional view of an organic film transistor according to a sixth embodiment;
Figure 7 is a schematic sectional view of an organic film transistor according to a seventh embodiment;
Figure 8 is a schematic sectional view of a solar cell according to an embodiment;
Figure 9 is a schematic sectional view of a photosensor according to a first embodiment;
Figure 10 is a schematic sectional view of a photosensor according to a second embodiment;
Figure 11 is a schematic sectional view of a photosensor according to a third embodiment;
Figure 12 is an ultraviolet visible absorption and fluorescence spectrum of Polymers A to D;
Figure 13 is a property diagram of Organic Film Transistor 1 in Example 4;
Figure 14 is a property diagram of Organic Film Transistor 2 in Example 5; and
Figure 15 is a property diagram of Organic Film Transistor 3 in Comparative Example 2.

### Explanation of Symbols

1: Substrate, 2: Active layer, 2a: Active layer, 3: Insulating layer, 4: Gate electrode, 5: Source electrode, 6: Drain electrode, 7a: First electrode, 7b: Second electrode, 8: Charge generating layer, 100: Organic film transistor according to a first embodiment, 110: Organic film transistor according to a second embodiment, 120: Organic film transistor according to a third embodiment, 130: Organic film transistor according to a fourth embodiment, 140: Organic film transistor according to a fifth embodiment, 150: Organic film transistor according to a sixth embodiment, 160: Organic film transistor according to a seventh embodiment, 200: Solar cell according to an embodiment, 300: Photosensor according to a first embodiment, 310: Photosensor according to a second embodiment, 320: Photosensor according to a third embodiment.

### Best Modes for Carrying Out the Invention

Hereinafter, referring to the drawings in some cases, suitable embodiments of the present invention will be described in detail. In the drawings, identical reference numerals will be given to identical components, and duplicating description thereof will be omitted. Positional relations such as four directions will be based on a positional relation shown in the drawings unless specified. Dimensional ratios of the drawings will not be limited to ratios shown.

A polymer according to the present invention may include at least one repeating structure represented by the above formula (1), and may include two or more kinds of the repeating structures represented by the formula (1). In the present embodiment, the polymer refers to those having two or more monomer structures, and includes those usually classified into an oligomer or a polymer. The repeating structure represented by the above formula (1) has a structure in which two identical structural units each formed of X, L, and T (one X, one L, and one T) are sequenced. Thus, by including the structure in which at least the two identical structural units are sequenced, the polymer according to the present invention, suppresses formation of an aggregation structure shown in a low molecular at the time of thin film formation to provide a uniform thin film. Additionally, the polymer according to the present invention can manifest stable and good charge transport property. The polymer according to the present invention may include a repeating structure represented by the following formula (1') as well as the repeating structure represented by the above formula (1).

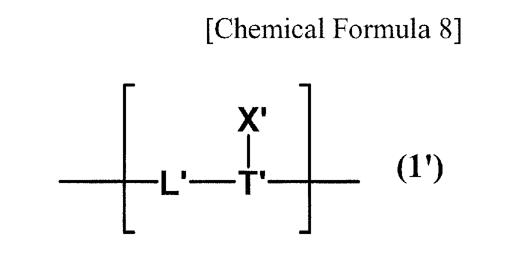

In the formula (1'), X', L', and T' are synonymous with X, L, and T in the formula (1), respectively, while X' and X, L' and L, and T' and T may be the same or may be different from each other, respectively.

In the above formula (1), L and X each independently have a configuration in which are linked a plurality of a conjugation forming structures conjugated by itself (a conjugation forming structure that causes conjugation by linking), and include at least one thienylene structure as the above-mentioned conjugation forming structure. In the formula (1), each X represents a monovalent organic group that may have a substituent, each L represents a divalent organic group that may have a substituent, and each T represents a trivalent organic group that may have a substituent.

When each L has the structure represented by the above formula (2) in the above formula (1), it is more preferable because the conjugate properties of the polymer further improve and charge transport property improves.

In the above formula (2), Ar¹ represents a divalent aromatic hydrocarbon group that may have a substituent or a divalent heterocyclic group that may have a substituent. R¹, R², R³, and R⁴ each independently represent a hydrogen atom, an alkyl group, an alkoxy group, an aryl group that may have a substituent, or a monovalent heterocyclic group that may have a substituent, and part or all of hydrogen atoms in each of these groups may be replaced by a fluorine atom. When there are a plurality of R¹'s, a plurality of R²'s, a plurality of R³'s, and a plurality of R⁴'s, the R¹'s may be the same as or different from each other, the R²'s may be the same as or different from each other, the R³'s may be the same as or different from each other, and the R⁴'s may be the same as or different from each other. Moreover, m, n, and o each independently represent an integer of 0 to 10. However, at least one of m and o is an integer of not less than one, m + n + o is an integer of 2 to 20, and preferably, m + n + o is an integer of 2 to 12.

From the viewpoint of enhancing the charge transport property, in the case where n is 0 in the above formula (2), in short, each L is preferably formed of a thiophene ring only, and more preferably, n = 0 and m + o is 2 to 12. From the viewpoint of enhancing solubility in an organic solvent to obtain an approximately uniform thin film, preferably at least one of R¹, R², R³, and R⁴ is not a hydrogen atom.

The polymer having a structure in which each L is represented by the above formula (2) has high conjugate properties, and also has particularly high stability of a compound. Accordingly, the polymer has higher charge transport property and demonstrates excellent properties when the polymer is used as an organic p-type semiconductor.

In the polymer according to the present invention, each T is preferably one of trivalent organic groups represented by the above formulas (3) to (7), and particularly preferably a trivalent organic group represented by the above formula (4'). In the formula (3), R⁵ represents a hydrogen atom, an alkyl group, an alkoxy group, an aryl group, or a cyano group.

In the polymer according to the present invention, a monovalent organic group represented by the above formula (8) is particularly preferable as each X in the above formula (1).

In the formula (8), Ar² represents a divalent aromatic hydrocarbon group that may have a substituent or a divalent heterocyclic group that may have a substituent. R⁶, R⁷, R⁸, and R⁹ each independently represent a hydrogen atom, an alkyl group, an alkoxy group, an aryl group that may have a substituent, or a monovalent heterocyclic group that may have a substituent, and part or all of hydrogen atoms in each of these groups may be replaced by a fluorine atom. When there are a plurality of R⁶'s, a plurality of R⁷'s, a plurality of R⁸'s, and a plurality of R⁹'s, the R⁶'s may be the same as or different from each other, the R⁷'s may be the same as or different from each other, the R⁸'s may be the same as or different from each other, and the R⁹'s may be the same as or different from each other. R¹⁰ represents a hydrogen atom or a monovalent group that may have a substituent. Moreover, p, q, and r each independently represent an integer of 0 to 10. However, at least one of p and r is an integer of not less than one, p + q + r is an integer of 2 to 20, and preferably, p + q + r is an integer of 2 to 12.

From the viewpoint of enhancing the charge transport property, in the case where q is 0 in the above formula (8), in short, each X that is a side chain is preferably formed of a thiophene ring only, and more preferably, q = 0 and p + r is 2 to 12. From the viewpoint of enhancing solubility in an organic solvent to obtain an approximately uniform thin film, preferably, at least one of R⁶, R⁷, R⁸, and R⁹ is not a hydrogen atom.

Such a polymer in which each X is the monovalent organic group represented by the above formula (8) has higher conjugate properties, and can be used as an organic p-type semiconductor having much higher charge transport property and stability. Particularly in the case where each X is the monovalent organic group represented by the above formula (8) and each L is the divalent organic group represented by the above formula (2), uniformity as the entire molecule is excellent, conjugate properties as the entire molecule are enhanced, and the charge transport property when the polymer is used as a p-type organic semiconductor is significantly improved.

The repeating structure represented by the above formula (1) is suitably a repeating structure represented by the following formula (9).

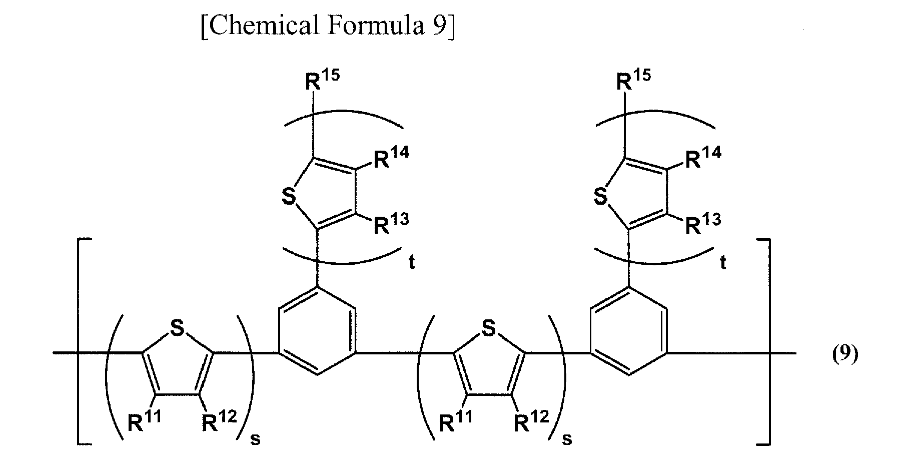

In the formula (9), R¹¹, R¹², R¹³, and R¹⁴ each independently represent a hydrogen atom, an alkyl group, an alkoxy group, an aryl group that may have a substituent, or a monovalent heterocyclic group that may have a substituent, and part or all of hydrogen atoms in each of these groups may be replaced by a fluorine atom. When there are a plurality of R¹¹'s, a plurality of R¹²'s, a plurality of R¹³'s, and a plurality of R¹⁴'s, the R¹¹'s may be the same as or different from each other, the R¹²'s may be the same as or different from each other, the R¹³'s may be the same as or different from each other, and the R¹⁴'s may be the same as or different from each other. R¹⁵ represents a hydrogen atom or a monovalent group that may have a substituent. Moreover, s and t each independently represent an integer of 2 to 12. However, in the formula (9), the R¹¹'s represent the same group, the R¹²'s represent the same group, the R¹³'s represent the same group, the R¹⁴'s represent the same group, and the R¹⁵'s represent the same group, respectively. Moreover, in the formula (9), s's represent the same integer, and t's represent the same integer, respectively.

The polymer according to the present invention preferably has at least one repeating structures represented by the above formula (1), and at least one repeating structures represented by the following formula (10) different from the repeating structure represented by the above formula (1). With the structure mentioned above, ranges where solubility and mechanical, thermal or electronic properties may be changed are wider. In the following formula (10), Ar³ represents a divalent aromatic hydrocarbon group that may have a substituent or a divalent heterocyclic group that may have a substituent. The ratio of the repeating structure represented by the above formula (1) and the repeating structure represented by following formula (10) is preferably 10 to 1000 mol of the latter based on 100 mol of the former, more preferably 25 to 400 mol of the latter based on 100 mol of the former, and still more preferably 50 to 200 mol of the latter based on 100 mol of the former.

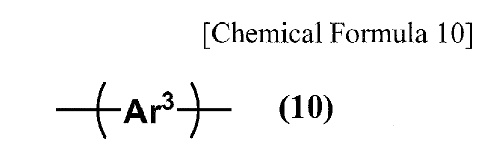

In the above formulas (2), (8), and (10), the divalent aromatic hydrocarbon groups represented by Ar¹, Ar², and Ar³ refer to the remaining atomic group after removing two hydrogen atoms from a benzene ring or a fused ring. The carbon number is usually 6 to 60, and preferably 6 to 20. Examples of the fused ring include a naphthalene ring, an anthracene ring, a tetracene ring, a pentacene ring, a pyrene ring, a perylene ring, a rubrene ring, and a fluorene ring. As the divalent aromatic hydrocarbon group, the remaining atomic groups after removing two hydrogen atoms from the benzene ring and the fluorene ring are particularly preferable. The aromatic hydrocarbon group may have a substituent thereon. Here, the carbon number in the substituent is not included in the carbon number in the divalent aromatic hydrocarbon group. Examples of the substituent include a halogen atom, a saturated or unsaturated hydrocarbon group, an aryl group, an alkoxy group, an aryloxy group, a monovalent heterocyclic group, an amino group, a nitro group, and a cyano group.

The divalent heterocyclic group represented by Ar¹, Ar², and Ar³ refers to the remaining atomic group after removing two hydrogen atoms from a heterocyclic compound. The carbon number is usually 4 to 60, and preferably 4 to 20. Here, the heterocyclic compound refers to not only those of organic compounds having a cyclic structure in which an element that forms the ring is a carbon atom, but also those that contain a hetero atom such as oxygen, sulfur, nitrogen, phosphorus, boron, and silicon in the ring. Examples of the heterocyclic compound include compounds obtained by ring-fusing 2 to 6 thiophene rings such as thiophene, thienothiophene, or dithienothiophene, pyrrole, pyridine, pyrimidine, pyrazine, and triazine. As the divalent heterocyclic group, the remaining atomic groups after removing two hydrogen atoms from thiophene, thienothiophene, and dithienothiophene are particularly preferable. The divalent heterocyclic group may have a substituent thereon, and the carbon number in the substituent is not included in the carbon number in the divalent heterocyclic group. Examples of the substituent include a halogen atom, a saturated or unsaturated hydrocarbon group, an aryl group, an alkoxy group, an aryloxy group, a monovalent heterocyclic group, an amino group, a nitro group, and a cyano group.

Moreover, in the polymer according to the present invention, the structure containing the repeating structure represented by the above formula (1) is preferably a structure represented by the following formula (11) or (12) from the viewpoint of enhancing the charge transport property.

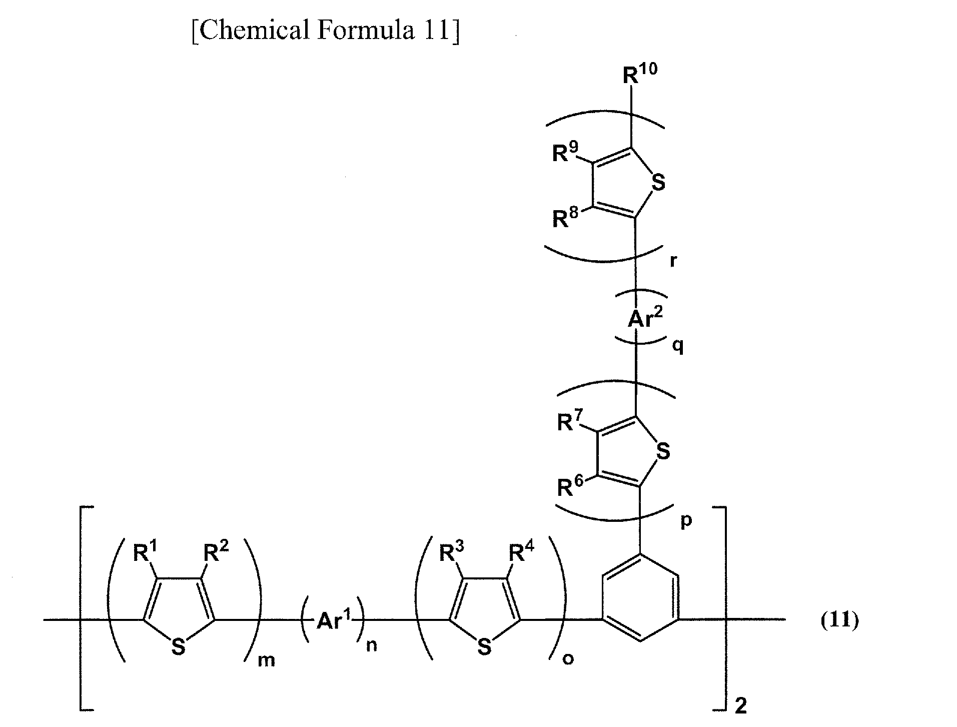

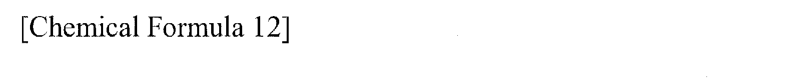

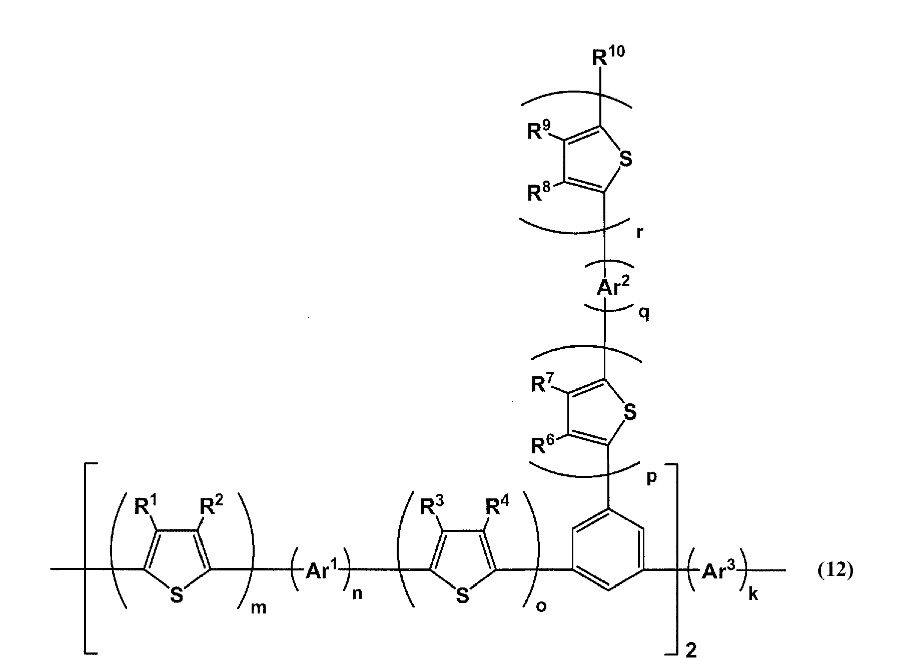

Here, R¹ to R¹⁰, Ar¹ to Ar³, m, n, o, p, q, and r are synonymous with those in the above descriptions. In the case where pluralities of R¹'s to R¹⁰'s and Ar¹'s to Ar³'s exist, the plurality of R¹'s, the plurality of R²'s, the plurality of R³'s, the plurality of R⁴'s, the plurality of R⁵'s, the plurality of R⁶'s, the plurality of R⁷'s, the plurality of R⁸'s, the plurality of R⁹'s, the plurality of R¹⁰'s, the plurality of Ar¹'s, the plurality of Ar²'s, and the plurality of Ar³'s may be the same or may be different from each other, respectively. k represents an integer of 1 to 10, preferably an integer of 1 to 6, and more preferably an integer of 1 to 3. Of these, a repeating structure in which n and q are 0 is particularly preferable.

In the polymer according to the present invention, examples of a terminal group (R¹⁶, R¹⁷, and the like described later) include a hydrogen atom, a fluorine atom, a hydroxy group, an alkyl group, an alkoxy group, an acyl group, an amino keto group, an aryl group, monovalent heterocyclic groups (part or all of hydrogen atoms bonded to each of these groups may be replaced by a fluorine atom), groups having an α-fluoroketone structure, electron donating groups, and electron withdrawing groups; and the alkyl group, the alkoxy group, and the aryl group are preferable. Terminal groups having a conjugated bond that is continuous to the conjugate structure of the principal chain are also preferable, and examples thereof include a structure bonded to an aryl group or a monovalent heterocyclic group through a carbon-carbon bond.

In the case where the polymer according to the present invention has a polymerization active group as the terminal group of the polymer, those can also be used as a precursor of the polymer. In that case, the polymer preferably has two polymerization active groups in the molecular. Examples of the polymerization active group include a halogen atom, an alkyl sulfonate group, an aryl sulfonate group, an aryl alkyl sulfonate group, an alkyl stannyl group, an aryl stannyl group, an aryl alkyl stannyl group, boric acid ester residues, a sulfonium methyl group, a phosphonium methyl group, a phosphonate methyl group, a monohalogenated methyl group, a boric acid residue, a formyl group, and a vinyl group. The halogen atom, the alkyl stannyl group, and the boric acid ester residues are preferable. Here, the boric acid residue represents a group (-B(OH)₂) having hydroxyl substituted on boron, and the boric acid ester residues represent the following groups, for example.

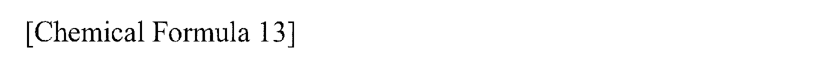

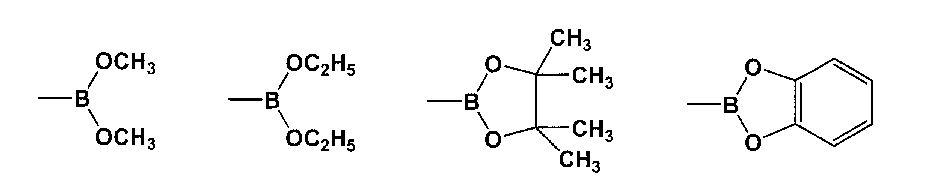

Moreover, in the case where the polymer according to the present invention is used as an organic film, when the polymerization active group remains in the terminal group as it is, properties and durability when the polymer is used as a device may be reduced. For that reason, the terminal group may be protected by a stable group.

Of the polymers of the present invention, particularly preferable polymers are represented by the following formulas (1-1) to (1-6).

**[Table 1]**

| | |
|---|---|
| (1-1) | 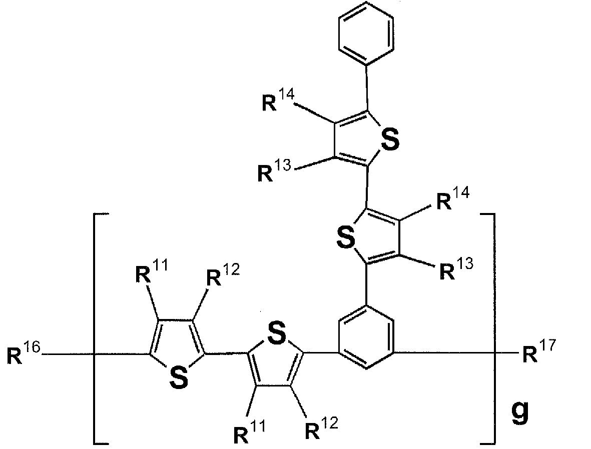 |
| (1-2) | 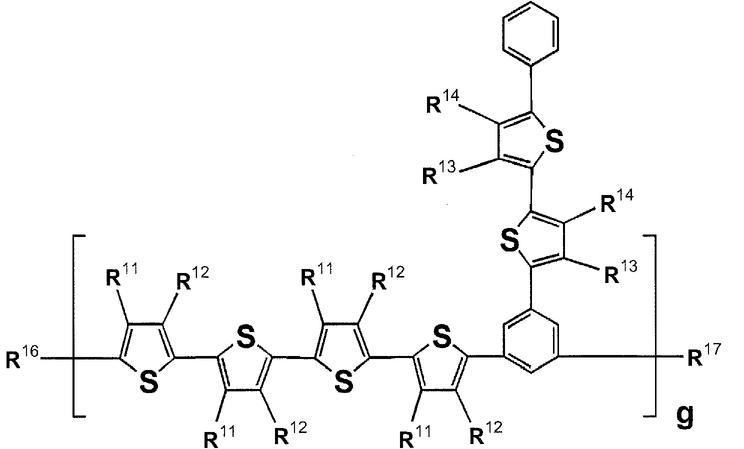 |
| (1-3) | 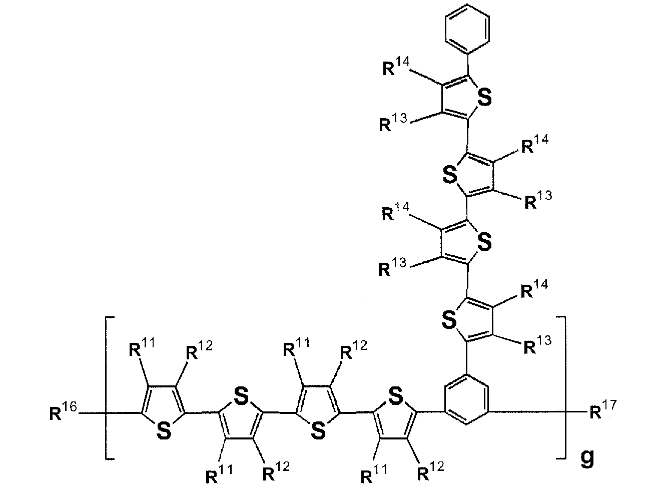 |

**[Table 2]**

| | |
|---|---|
| (1-4) | 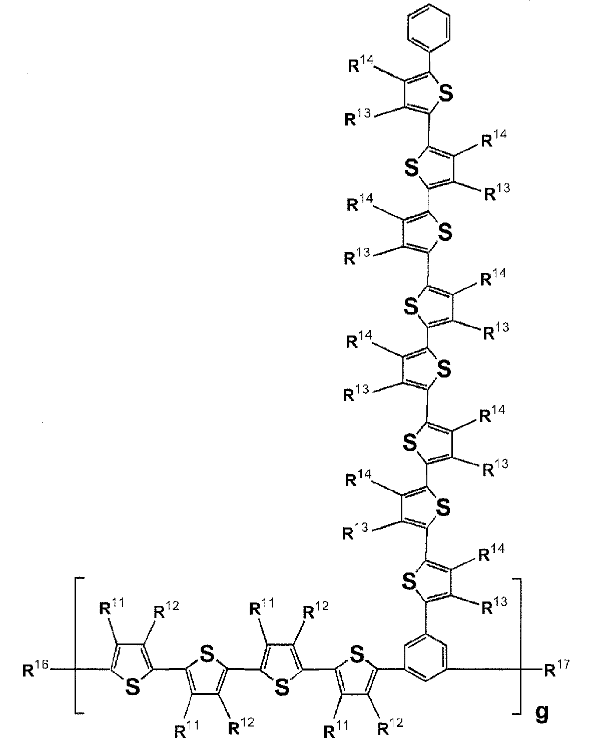 |

**[Table 3]**

| | |
|---|---|
| (1-5) | 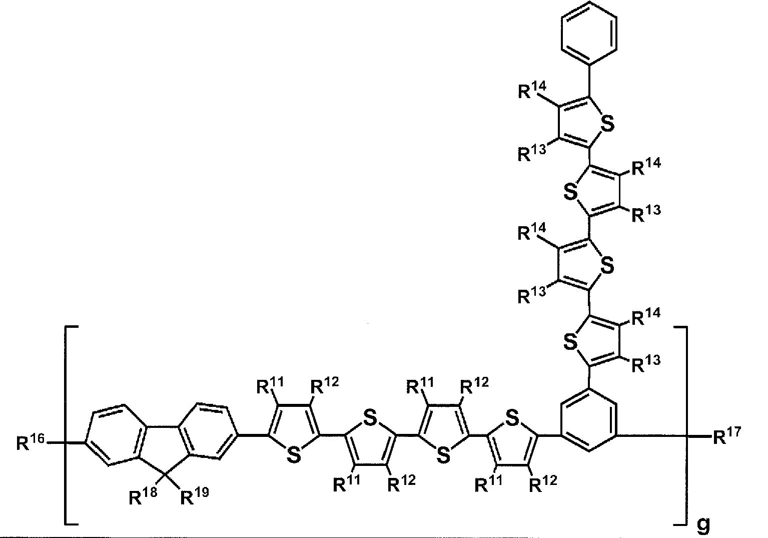 |
| (1-6) | 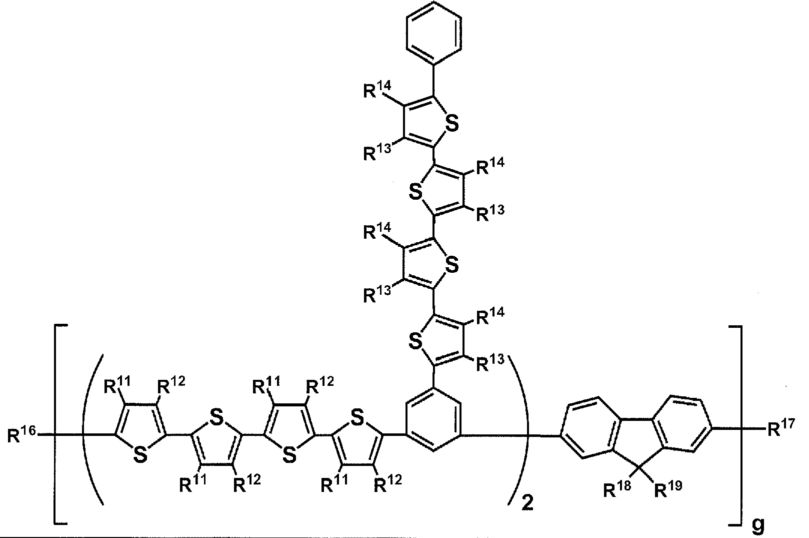 |

Here, R¹¹, R¹², R¹³, and R¹⁴ are synonymous with those in the above descriptions. R¹⁶ and R¹⁷ represent the terminal group, and may be the same or may be different from each other. Examples thereof include the terminal groups mentioned above, and a hydrogen atom, a hydroxy group, an alkyl group, an alkoxy group, and an aryl group are preferable. R¹⁸ and R¹⁹ each independently represent a hydrogen atom or a substituent. An alkyl group, an alkoxy group, or an aryl group is preferable, and the alkyl group is more preferable. In the case where a plurality of R¹¹'s, a plurality of R¹²'s , a plurality of R¹³'s, a plurality of R¹⁴'s, a plurality of R¹⁸'s, and a plurality of R¹⁹'s exist in the polymer, those may be the same or may be different from each other, respectively. For easiness of production, preferably, the plurality of R¹¹'s that exist are the same, the plurality of R¹²'s that exist are the same, the plurality of R¹³'s that exist are the same, the plurality of R¹⁴'s that exist are the same, the plurality of R¹⁸'s that exist are the same, and the plurality of R¹⁹'s that exist are the same, respectively. g can be properly selected according to a method for forming an organic film in which the polymer is used. However, g is not less than two, and at least two structural units in which R¹¹, R¹², R¹³, R¹⁴, R¹⁸, and R¹⁹ are the same need to be sequenced. When the polymer has sublimability, the polymer can be formed into an organic film using vapor phase growth such as a vacuum evaporation method. In this case, g is preferably 2 to 10, and more preferably 2 to 5. On the other hand, in the case where the polymer is formed into an organic film using a method for applying a solution obtained by dissolving the polymer in an organic solvent, g is preferably 3 to 500, more preferably 6 to 300, and still more preferably 20 to 200. From the viewpoint of uniformity of the film when the film is formed by application, the number average molecular weight of the polymer in terms of polystyrene conversion is preferably 1 × 10³ to 1 × 10⁸, more preferably 1 × 10³ to 1 × 10⁶, and still more preferably 5 × 10³ to 1 × 10⁵.

In each of the formulas mentioned above, as the monovalent group represented by R¹⁰ and R¹⁵, a linear or branched low molecular chain, and a monovalent cyclic group (this cyclic group may be a monocyclic ring or a fused ring, a carbocyclic ring or a heterocyclic ring, saturated or unsaturated, or have a substituent or no substituent) are preferable. The monovalent group may be electron donating groups or may be electron withdrawing groups.

Moreover, the monovalent group represented by R¹⁰ and R¹⁵ is more preferably a linear or branched low molecular chain (referring to those having a carbon number of 1 to 20), a monovalent cyclic group having the number of ring-forming atoms of 3 to 60 (this cyclic group may be a monocyclic ring or a fused ring, a carbocyclic ring or a heterocyclic ring, saturated or unsaturated, or have a substituent or no substituent), a saturated or unsaturated hydrocarbon group, a hydroxy group, an alkoxy group, an alkanoloxy group, an amino group, an oxyamino group, an alkylamino group, a dialkylamino group, an alkanoyl amino group, a cyano group, a nitro group, a sulfo group, an alkyl group substituted with one or more halogen atoms, an alkoxy sulfonyl group (provided that the alkyl group may be substituted with one or more halogen atoms), an alkyl sulfonyl group (provided that the alkyl group may be substituted with one or more halogen atoms), a sulfamoyl group, an alkyl sulfamoyl group, a carboxyl group, a carbamoyl group, an alkyl carbamoyl group, an alkanoyl group, or an alkoxycarbonyl group.

In the present invention, examples of the halogen atom include a fluorine atom, a chlorine atom, a bromine atom, and an iodine atom.

In each of the formulas mentioned above, as the alkyl group represented by R¹ to R¹⁷, a linear, branched, or cyclic alkyl group having a carbon number of 1 to 20 is preferable, and examples thereof include a methyl group, an ethyl group, an n-propyl group, an iso-propyl group, an n-butyl group, an iso-butyl group, a tert-butyl group, a pentyl group, a hexyl group, a heptyl group, an octyl group, a nonyl group, a decyl group, a lauryl group, a cyclopropyl group, a cyclobutyl group, a cyclopentyl group, a cyclohexyl group, a cycloheptyl group, a cyclooctyl group, a cyclononyl group, and a cyclododecyl. The alkyl group having a carbon number of 1 to 12 is more preferable, and the pentyl group, the hexyl group, the octyl group, the decyl group, and the cyclohexyl group are more preferable.

Examples of the alkoxy group represented by R¹ to R¹⁷ include an alkoxy group containing the above-mentioned alkyl group in the structure.

As the aryl group represented by R¹ to R¹⁷, an aryl group having a carbon number of 6 to 60 is preferable, and examples thereof include a phenyl group, a C¹-C¹² alkoxy phenyl group (C¹-C¹² refers to that the carbon number is 1 to 12. Hereinafter, this is the same.), a C¹-C¹² alkylphenyl group, a 1-naphthyl group, and a 2-naphthyl group. An aryl group having a carbon number of 6 to 20 is preferable, the phenyl group, the C¹-C¹² alkoxy phenyl group, the C¹-C¹² alkylphenyl group are more preferable, and the phenyl group is still more preferable.

As the monovalent heterocyclic group represented by R¹ to R¹⁷, a monovalent heterocyclic group having a carbon number of 4 to 60 is preferable, and examples thereof include a thienyl group, a C¹-C¹² alkyl thienyl group, a pyrrolyl group, a furil group, a pyridyl group, and a C¹-C¹² alkyl pyridyl group. A heterocyclic group having a carbon number of 4 to 20 is preferable, and the thienyl group, the C¹-C¹² alkyl thienyl group, the pyridyl group, and the C¹-C¹² alkyl pyridyl group are more preferable.

Examples of the unsaturated hydrocarbon group represented by R¹⁰ and R¹⁵ include a vinyl group, a 1-propenyl group, an allyl group, a propargyl group, an isopropenyl group, a 1-butenyl group, and a 2-butenyl group, and a vinyl group is preferable.

Examples of the alkanoyl group include a formyl group, an acetyl group, a propionyl group, an isobutyryl group, a valeryl group, and an isovaleryl group, and this is true of groups containing the alkanoyl group in the structure (an alkanoyloxy group, an alkanoyl amino group, and the like). Moreover, an alkanoyl group having a carbon number of 1 indicates a formyl group, and this is true of groups containing the alkanoyl group in the structure. Preferable examples of the alkanoyl group include a formyl group and an acetyl group.

The polymer according to the present invention may be produced by any kind of methods, and is preferably produced with a production method described below.

First, a method for producing a polymer according to the present invention will be described. The polymer represented by the above formula (1) can be produced by using compounds represented by the following formulas (a), (b), and (d) as a raw material and reacting these compounds, for example. As an example, a precursor (c) is produced using starting materials represented by the following formulas (a) and (b) according to the following scheme. The polymer can be produced by a step of reacting this precursor with the starting material represented by (d). A production method including a step of introducing a terminal group is preferably used.

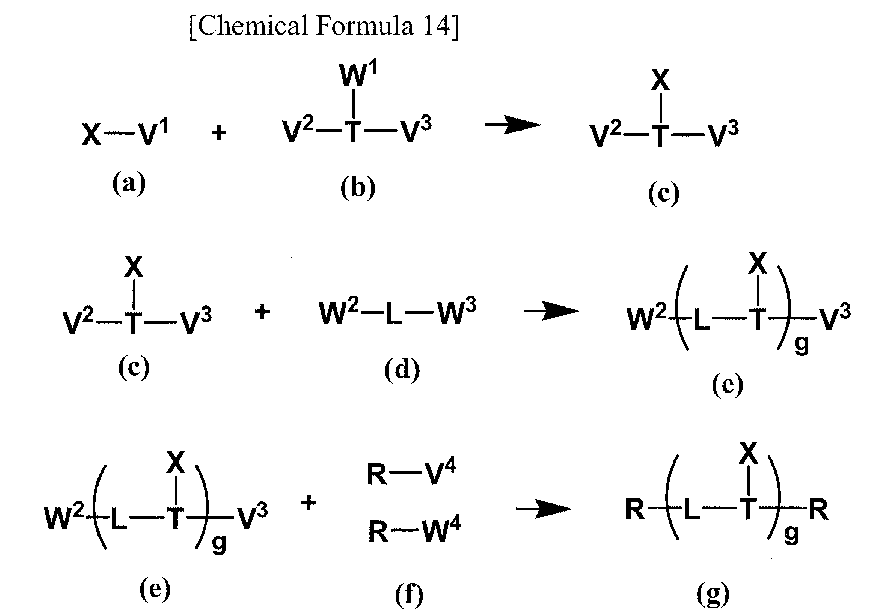

Here, X, L, and T are synonymous with those in the above descriptions, and R is synonymous with R¹⁶ and R¹⁷ above. V¹ to V⁴ and W¹ to W⁴ represent a reaction active group, and may be the same or may be different from each other. V¹ to V⁴ and W¹ to W⁴ represent a halogen atom, an alkyl sulfonate group, an aryl sulfonate group, an aryl alkyl sulfonate group, an alkyl stannyl group, an aryl stannyl group, an aryl alkyl stannyl group, a boric acid ester residue, a sulfonium methyl group, a phosphonium methyl group, a phosphonate methyl group, a monohalogenated methyl group, a boric acid residue, a formyl group, or a vinyl group.

From the viewpoint of easiness of the reaction on synthesis, it is preferable that V¹ to V⁴ and W¹ to W⁴ each independently be a halogen atom, an alkyl sulfonate group, an aryl sulfonate group, an aryl alkyl sulfonate group, an alkyl stannyl group, a boric acid ester residue, and a boric acid residue.

V¹ to V⁴ and W¹ to W⁴ may be properly selected according to a coupling reaction to be used, and are preferably selected so that only the reaction active groups represented by V^{z} and W^{z} (z is 1 to 4) may react.

In the above reaction step, in order to protect a functional group having high reactivity, a step of converting the functional group into an inactive functional group (protecting group) in the subsequent reaction and a step of removing the protecting group after the target reaction is terminated may be included. The protecting group can be properly selected according to the functional group to be protected and the reaction to be used, and trimethylsilyl (TMS), triethyl silyl (TES), tert-butyldimethylsilyl (TBS or TBDMS), triisopropyl silyl (TIPS), and tert-butyldiphenylsilyl (TBDPS) are preferably used for protection of active hydrogen, for example.

A solvent may be used in the above reaction step. Preferably, the solvent to be used does not inhibit the target reaction as much as possible, and examples thereof include aliphatic hydrocarbons such as hexane, aromatic hydrocarbons such as benzene and toluene, nitrils such as acetonitrile, ethers such as diethylether, tetrahydrofuran, and 1,2-dimethoxyethane, halogenated solvents such as dichloromethane, 1,2-dichloroethane, and carbon tetrachloride. These may be used alone, or two or more kinds thereof may be used in combination. Suitable examples of the solvent include dichloromethane.

In the case where the polymer according to the present invention is used as a material for an organic film device, purification treatment of the produced compound is preferably performed with a method such as distillation, sublimation refining, and recrystallization because purity of the polymer influences the properties of the device.

The reaction conditions, the reaction reagent, and the like in the above production method can be properly selected other than those shown above. The polymer according to the present invention is preferably produced with the above production method as mentioned above.

Examples of reaction methods used for production of the polymer according to the present invention include a method using a Wittig reaction, a method using a Heck reaction, a method using a Homer-Wadsworth-Emmons reaction, a method using a Knoevenagel reaction, a method using a Suzuki coupling reaction, a method using a Grignard reaction, a method using a Stille reaction, a method using an Ni(0) catalyst, a method using an oxidizer such as FeCl₃, a method using an electrochemical oxidation reaction, and a method by decomposition of an intermediate compound having an appropriate leaving group.

Of these, the method using a Wittig reaction, the method using a Heck reaction, the method using a Horner-Wadsworth-Emmons reaction, the method using a Knoevenagel reaction, the method using a Suzuki coupling reaction, the method using a Grignard reaction, the method using a Stille reaction, and the method using an Ni(0) catalyst are preferable for easy control of the structure. Further, the method using a Suzuki coupling reaction, the method using a Grignard reaction, the method using a Stille reaction, and the method using an Ni(0) catalyst are preferable for availability of the raw materials and simple reaction operation.

The starting material at the time of producing the polymer according to the present invention (the compound represented by the above formula (a), (b), or (d)) is dissolved in an organic solvent when necessary, and can be reacted at a temperature of not less than the melting point of the organic solvent and not more than the boiling point thereof by using an alkali or an appropriate catalyst.

The organic solvent varies depending on the compound and reaction to be used. Usually, in order to suppress a side reaction, it is preferable that the solvent to be used be subjected to sufficient deoxidation treatment and the reaction be in progress under an inert atmosphere. Moreover, dehydrating treatment is preferably performed in the same way (however, in the case of a reaction in two phase system with water such as a Suzuki coupling reaction, this is not the case).

Upon producing the polymer according to the present invention, in order to cause a reaction, an alkali or an appropriate catalyst can be added properly. These may be selected according to the reaction to be used. This alkali or catalyst is preferably those sufficiently dissolved in a solvent used for the reaction.

In the case where the polymer according to the present invention is used as a material for an organic film device, a monomer before the reaction is preferably refined with a method such as distillation, sublimation refining, or recrystallization, and subsequently is polymerized because purity of the polymer influences the properties of the device. Moreover, after synthesis of the polymer, the polymer is preferably subjected to a purification treatment such as reprecipitation refining and separation by chromatography.

Examples of the solvent used for the reaction include saturated hydrocarbons such as pentane, hexane, heptane, octane, and cyclohexane; unsaturated hydrocarbons such as benzene, toluene, ethylbenzene, and xylenes; halogenated saturated hydrocarbons such as carbon tetrachloride, chloroform, dichloromethane, chlorobutane, bromobutane, chloropentane, bromopentane, chlorohexane, bromohexane, chlorocyclohexane, and bromocyclohexane; halogenated unsaturated hydrocarbons such as chlorobenzene, dichlorobenzene, and trichlorobenzene; alcohols such as methanol, ethanol, propanol, isopropanol, butanol, and tert-butyl alcohol; carboxylic acids such as formic acid, acetic acid, and propionic acid; ethers such as dimethyl ether, diethylether, methyl-tert-butyl ether, tetrahydrofuran, tetrahydropyran, and dioxane; and inorganic acids such as chloride, bromic acid, hydrofluoric acid, sulfuric acid, and nitric acid. One kind of the above solvents may be used alone, or two or more kinds thereof may be used in combination.

After the reaction, the product can be obtained through a conventional post-treatment to extract the organic solvent after quenching with water, and distil off the solvent, for example. Isolation and refining of the product can be performed with a method such as preparative isolation by chromatography and recrystallization.

Next, an organic film according to the present invention will be described. The organic film according to the present invention contains the polymer according to the present invention.

The film thickness of the organic film is usually approximately 1 nm to 100 µm, preferably 2 nm to 1000 nm, more preferably 5 nm to 500 nm, and particularly preferably 20 nm to 200 nm.

The organic film may contain one kind of the above polymers alone, or may contain two or more kinds of the above polymers. Moreover, other than the above polymers, in order to enhance the electron transport property or hole transport property of the organic film, a low molecular compound or high molecular compound having the electron transport property or hole transport property can also be mixed and used.

Known materials can be used as a hole transporting material, and examples thereof include pyrazoline derivatives, arylamine derivatives, stilbene derivatives, triaryl diamine derivatives, oligothiophenes and derivatives thereof, polyvinyl carbazoles and derivatives thereof, polysilanes and derivatives thereof, polysiloxane derivatives having aromatic amine in the side chain or principal chain thereof, polyanilines and derivatives thereof, polythiophenes and derivatives thereof, polypyrroles and derivatives thereof, polyarylene vinylenes and derivatives thereof, and polythienylene vinylenes and derivatives thereof. Known materials can be used as an electron transporting material, and examples thereof include oxadiazole derivatives, anthraquinodimethanes and derivatives thereof, benzoquinones and derivatives thereof, naphthoquinones and derivatives thereof, anthraquinones and derivatives thereof, tetracyano anthraquinodimethane and derivatives thereof, fluorenone derivatives, diphenyl dicyanoethylene and derivatives thereof, diphenoquinone derivatives, 8-hydroxyquinoline and metal complexes of derivatives thereof, polyquinolines and derivatives thereof, polyquinoxalines and derivatives thereof, polyfluorenes and derivatives thereof, and fullerenes such as C₆₀ and derivatives thereof.

The organic film according to the present invention may also contain a charge generating material in order to generate charges by light absorbed in the organic film. Known materials can be used as the charge generating material, and examples thereof include azo compounds and derivatives thereof, diazo compounds and derivatives thereof, non-metal phthalocyanine compounds and derivatives thereof, metal phthalocyanine compounds and derivatives thereof, perylene compounds and derivatives thereof, polycyclic quinone based compounds and derivatives thereof, squarylium compounds and derivatives thereof, azurenium compounds and derivatives thereof, thia pyrylium compounds and derivatives thereof, and fullerenes such as C₆₀ and derivatives thereof.

The organic film according to the present invention may further contain a material needed to manifest various functions. Examples of this material include a sensitizer for sensitizing the function to generate charges by the absorbed light, a stabilizing agent for enhancing stability, and a UV absorbent for absorbing UV light.

Moreover, in order to enhance mechanical properties, the organic film according to the present invention may contain a high molecular compound material other than the above polymer as a polymer binder. As the polymer binder, binders that do not extremely inhibit the electron transport property or hole transport property and binders having not intensive absorption of visible light are preferable.

Examples of such a polymer binder include poly(N-vinylcarbazole), polyanilines and derivatives thereof, polythiophenes and derivatives thereof, poly(p-phenylenevinylene) and derivatives thereof, poly(2,5-thienylene vinylene) and derivatives thereof, polycarbonates, polyacrylates, poly(methyl acrylates), poly(methyl methacrylates), polystyrenes, polyvinyl chlorides, and polysiloxanes.

Examples of the methods for producing an organic film according to the present invention include a method for forming a film from a solution containing the above polymer, the electron transporting material or hole transporting material mixed when necessary, and the polymer binder mixed when necessary. The polymer according to the present invention can also be formed into a thin film with a vacuum evaporation method.

A solvent used for film formation from the solution may be those that dissolve the polymer, the electron transporting material or hole transporting material, and the polymer binder to be mixed.

Examples of the solvent used in the case where the organic film according to the present invention is formed from a solution include unsaturated hydrocarbon-based solvents such as toluene, xylenes, mesitylene, tetralin, decalin, bicyclohexyl, n-butylbenzene, sec-butylbenzene, and tert-butylbenzene; halogenated saturated hydrocarbon-based solvents such as carbon tetrachloride, chloroform, dichloromethane, dichloroethane, chlorobutane, bromobutane, chloropentane, bromopentane, chlorohexane, bromohexane, chlorocyclohexane, and bromocyclohexane; halogenated unsaturated hydrocarbon-based solvents such as chlorobenzene, dichlorobenzene, and trichlorobenzene; and ether based solvents such as tetrahydrofuran and tetrahydropyran. Depending on the structure or molecular weight of the polymer, not less than 0.1% by mass of the polymer can be usually dissolved in these solvents.

Coating methods such as a spin coating method, a casting method, a micro gravure coating method, a gravure coating method, a bar coating method, a roll coating method, a wire bar coating method, a dip coating method, a spray coating method, a screen printing method, a flexographic printing method, an offset printing method, an ink jet printing method, and a dispenser printing method can be used for film formation from the solution. Preferably, the spin coating method, the flexographic printing method, the ink jet printing method, and the dispenser printing method are used.

The organic film according to the present invention has electron transport property or hole transport property to control transportation of the electrons or holes injected from an electrode or the charges generated by absorption of the light. Accordingly, the organic film according to the present invention can be used for various organic film devices such as organic film transistors, organic solar cells, and photosensors.

The organic film according to the present invention has hole transport property to control transportation of the holes injected from an electrode or the holes generated by absorption of the light. Accordingly, the organic film according to the present invention can be used for various organic film devices such as organic electroluminescence devices, organic transistors, organic solar cells, and photosensors.

Next, application of the organic film according to the present invention to an organic film transistor will be described. The organic film transistor may have a structure including a source electrode and a drain electrode; an organic film layer (active layer) that serves as a current path between these source electrode and drain electrode and contains the polymer according to the present invention; and a gate electrode that controls an amount of current that passes through the current path. Examples thereof include a field effect type and an static induction type.

The field effect type organic film transistor preferably comprises a source electrode and a drain electrode; an organic film layer (active layer) that serves as a current path between these source electrode and drain electrode and contains the polymer according to the present invention; a gate electrode that controls an amount of current that passes through the current path; and an insulating layer disposed between the active layer and the gate electrode. Particularly preferably, the source electrode and the drain electrode are provided so as to contact the organic film layer (active layer) containing the polymer according to the present invention, and the gate electrode is further provided so that the insulating layer contacting the organic film layer may be interposed between the gate electrode and the organic film.

The static induction type organic film transistor comprises a source electrode and a drain electrode; an organic film layer that serves as a current path between these source electrode and drain electrode and contains the polymer according to the present invention; and a gate electrode that controls an amount of current that passes through the current path. The gate electrode is preferably provided in the organic film layer. Particularly preferably, the source electrode, the drain electrode, and the gate electrode provided in the organic film layer are provided so as to contact the organic film layer containing the polymer according to the present invention. The structure of the gate electrode may have a structure in which the current path flowing from the source electrode to the drain electrode can be formed, and the amount of the current that flows through the current path can be controlled by voltage applied to the gate electrode. Examples of the gate electrode include a comb-shaped electrode.

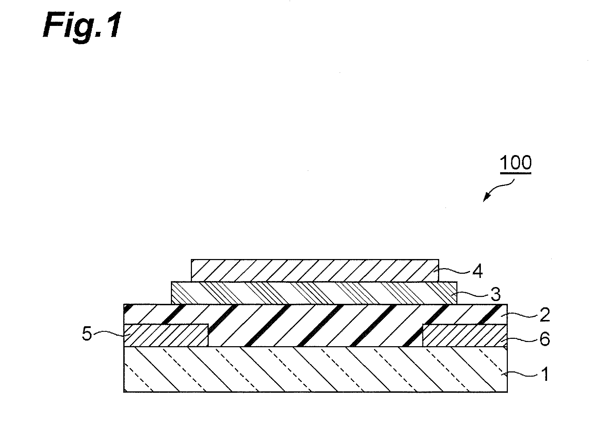

Figure 1 is a schematic sectional view of an organic film transistor (field effect type organic film transistor) according to a first embodiment. The organic film transistor 100 shown in Figure 1 comprises a substrate 1; a source electrode 5 and a drain electrode 6 formed at a predetermined interval on the substrate 1; an active layer 2 formed on the substrate 1 so as to cover the source electrode 5 and the drain electrode 6; an insulating layer 3 formed on the active layer 2; and a gate electrode 4 formed on the insulating layer 3 so as to cover a region of the insulating layer 3 between the source electrode 5 and the drain electrode 6.

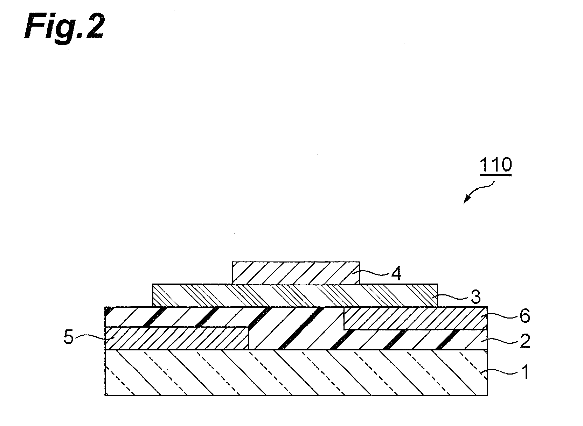

Figure 2 is a schematic sectional view of an organic film transistor (field effect type organic film transistor) according to a second embodiment. The organic film transistor 110 shown in Figure 2 comprises a substrate 1; a source electrode 5 formed on the substrate 1; an active layer 2 formed on the substrate 1 so as to cover the source electrode 5; a drain electrode 6 formed on the active layer 2 at an predetermined interval from the source electrode 5; an insulating layer 3 formed on the active layer 2 and the drain electrode 6; and a gate electrode 4 formed on the insulating layer 3 so as to cover a region of the insulating layer 3 between the source electrode 5 and the drain electrode 6.

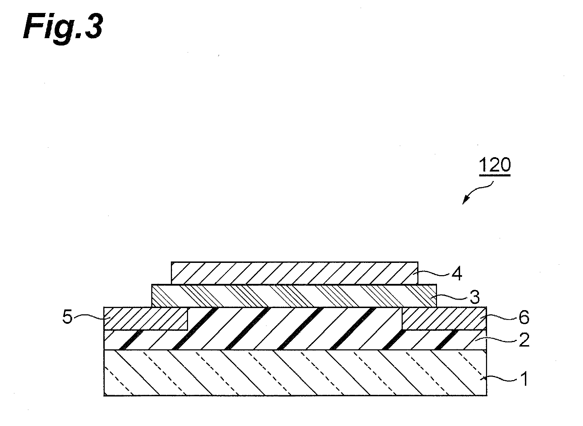

Figure 3 is a schematic sectional view of an organic film transistor (field effect type organic film transistor) according to a third embodiment. The organic film transistor 120 shown in Figure 3 comprises a substrate 1; an active layer 2 formed on the substrate 1; a source electrode 5 and a drain electrode 6 formed at a predetermined interval on the active layer 2; an insulating layer 3 formed on the active layer 2 so as to cover a part of the source electrode 5 and the drain electrode 6; and a gate electrode 4 formed on the insulating layer 3 so as to respectively cover a part of a region of the insulating layer 3 under which the source electrode 5 is formed and a part of a region of the insulating layer 3 under which the drain electrode 6 is formed.

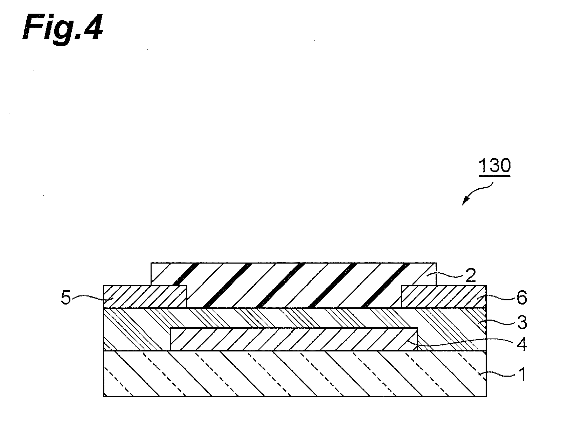

Figure 4 is a schematic sectional view of an organic film transistor (field effect type organic film transistor) according to a fourth embodiment. The organic film transistor 130 shown in Figure 4 comprises a substrate 1; a gate electrode 4 formed on the substrate 1; an insulating layer 3 formed on the substrate 1 so as to cover the gate electrode 4; a source electrode 5 and a drain electrode 6 formed at a predetermined interval on the insulating layer 3 so as to cover a part of a region of the insulating layer 3 under which the gate electrode 4 is formed; and an active layer 2 formed on the insulating layer 3 so as to cover a part of the source electrode 5 and the drain electrode 6.

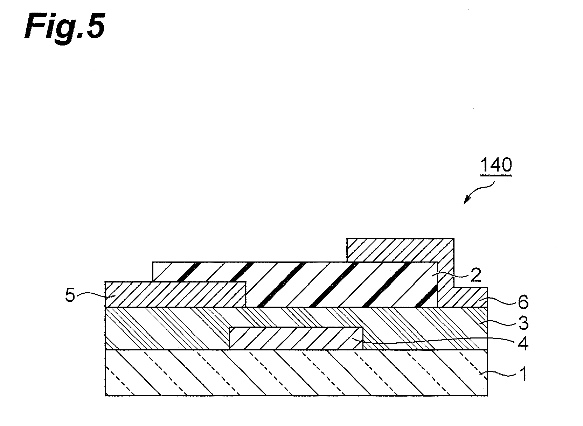

Figure 5 is a schematic sectional view of an organic film transistor (field effect type organic film transistor) according to a fifth embodiment. The organic film transistor 140 shown in Figure 5 comprises a substrate 1; a gate electrode 4 formed on the substrate 1; an insulating layer 3 formed on the substrate 1 so as to cover the gate electrode 4; a source electrode 5 formed on the insulating layer 3 so as to cover a part of a region of the insulating layer 3 under which the gate electrode 4 is formed; an active layer 2 formed on the insulating layer 3 so as to cover a part of the source electrode 5; and a drain electrode 6 formed on the insulating layer 3 at a predetermined interval from the source electrode 5 so as to cover a part of a region of the active layer 2 under which the gate electrode 4 is formed.

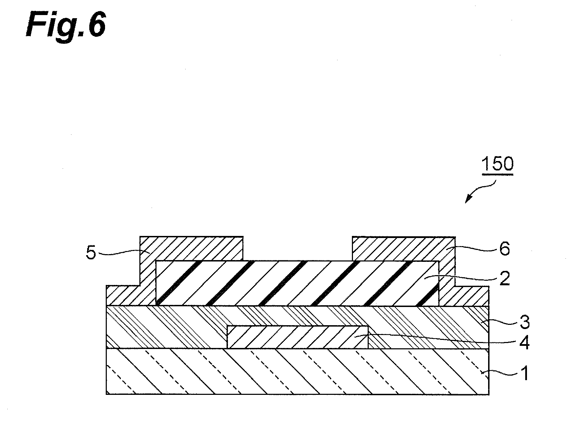

Figure 6 is a schematic sectional view of an organic film transistor (field effect type organic film transistor) according to a sixth embodiment. The organic film transistor 150 shown in Figure 6 comprises a substrate 1; a gate electrode 4 formed on the substrate 1; an insulating layer 3 formed on the substrate 1 so as to cover the gate electrode 4; an active layer 2 formed so as to cover a region of the insulating layer 3 under which the gate electrode 4 is formed; a source electrode 5 formed on the insulating layer 3 so as to cover a part of region of the active layer 2 under which the gate electrode 4 is formed; and a drain electrode 6 formed on the insulating layer 3 at a predetermined interval from the source electrode 5 so as to cover a part of a region of the active layer 2 under which the gate electrode 4 is formed.

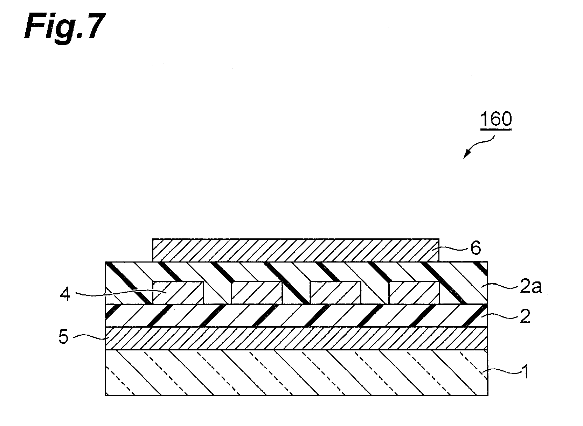

Figure 7 is a schematic sectional view of an organic film transistor (static induction type organic film transistor) according to a seventh embodiment. The organic film transistor 160 shown in Figure 7 comprises a substrate 1; a source electrode 5 formed on the substrate 1; an active layer 2 formed on the source electrode 5; a plurality of gate electrodes 4 formed at predetermined interval on the active layer 2; an active layer 2a formed on the active layer 2 so as to cover all over the gate electrodes 4 (a material that forms the active layer 2a may be the same as or may be different from that of the active layer 2); and a drain electrode 6 formed on the active layer 2a.

In the organic film transistors according to the first to seventh embodiments, the active layer 2 and/or the active layer 2a contain the polymer according to the present invention, and serve as the current path (channel) between the source electrode 5 and the drain electrode 6. The gate electrode 4 controls the amount of the current passing through the current path (channel) in the active layer 2 and/or the active layer 2a by applying voltage to the gate electrode 4.

Such a field effect type organic film transistor can be produced by a known method, for example, a method described in Japanese Patent Application Laid-Open Publication No. 05-110069. Moreover, the static induction type organic film transistor can be produced by a known method, for example, a method described in Japanese Patent Application Laid-Open Publication No. 2004-006476.

The substrate 1 may be any material that does not inhibit properties as the organic film transistor, and a glass substrate, a flexible film substrate, and a plastic substrate can be used for the substrate 1.

In forming the active layer 2, use of a compound having solubility in an organic solvent is very advantageous on production, and preferable. Accordingly, the organic film serving as the active layer 2 can be formed using the method for producing an organic film according to the present invention described above.

The insulating layer 3 contacting the active layer 2 may be any material having high electric insulation, and known materials can be used for the insulating layer 3. Examples of this material include SiOₓ, SiNₓ, Ta₂O₅, polyimides, polyvinyl alcohols, polyvinyl phenols, and organic glasses, and from the viewpoint of reduction in voltage, materials having high dielectric constant are more preferable.

In the case where the active layer 2 is formed on the insulating layer 3, in order to improve the interfacial properties between the insulating layer 3 and the active layer 2, the active layer 2 can also be formed after the insulating layer 3 surface is treated with a surface treating agent such as a silane coupling agent to undergo surface modification. Examples of the surface treating agent include long-chain alkylchlorosilanes, long-chain alkylalkoxysilanes, fluorinated alkylchlorosilanes, fluorinated alkylalkoxysilanes, and silylamine compounds such as hexamethyldisilazane. Before treatment with the surface treating agent, the surface of the insulating layer can also be treated with ozone UV or O₂ plasma.

After production of the organic film transistor, a protective film is preferably formed on the organic film transistor in order to protect the device. Thereby, the organic film transistor is shut off from the air, and reduction in the properties of the organic film transistor can be suppressed. Moreover, the protective film can reduce an influence when a display device driven is formed on the organic film transistor.

Examples of methods for forming a protective film include a method for covering the organic film transistor with a UV curing resin, a thermosetting resin, or an inorganic SiONₓ film. In order to perform shutoff from the air effectively, the step after production of the organic film transistor to the step of forming the protective film are preferably performed without exposing the organic film transistor to the air (for example, in a drying nitrogen atmosphere, in vacuum, and the like).

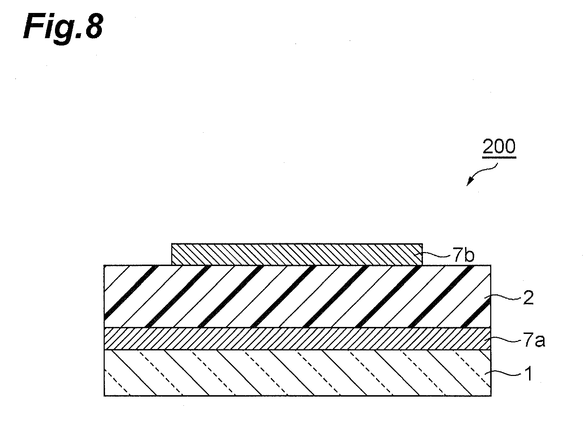

Next, application of the organic film according to the present invention to solar cells will be described. Figure 8 is a schematic sectional view of a solar cell according to an embodiment. The solar cell 200 shown in Figure 8 comprises a substrate 1, a first electrode 7a formed on the substrate 1, an active layer 2 formed on the first electrode 7a and formed of the organic film containing the polymer according to the present invention, and a second electrode 7b formed on the active layer 2.

A transparent or semi-transparent electrode is used for one of the first electrode 7a and the second electrode 7b in the solar cell according to the present embodiment. As a material for the electrode, metals such as aluminum, gold, silver, copper, alkali metals, and alkaline earth metals, and semi-transparent films thereof, and transparent conductive films can be used. In order to obtain high open circuit voltage, the respective electrodes are preferably selected so as to have a large difference in work function. In order to increase photosensitivity in the active layer 2 (organic film), a carrier generating agent, a sensitizer, and the like can be added and used. As the substrate 1, a silicon substrate, a glass substrate, a plastic substrate, and the like can be used.

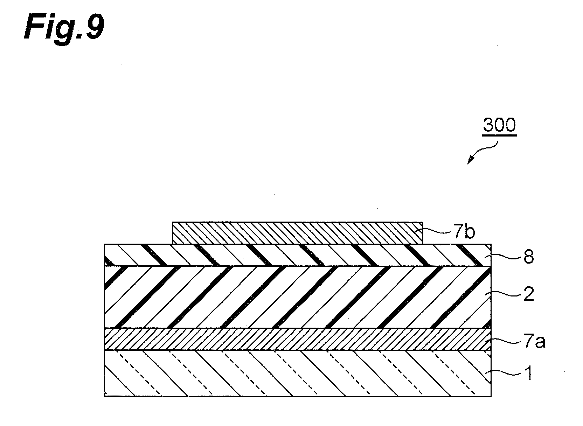

Next, application of the organic film according to the present invention to photosensors will be described. Figure 9 is a schematic sectional view of a photosensor according to a first embodiment. The photosensor 300 shown in Figure 9 comprises a substrate 1, a first electrode 7a formed on the substrate 1, an active layer 2 formed on the first electrode 7a and formed of the organic film containing the polymer according to the present invention, a charge generating layer 8 formed on the active layer 2, and a second electrode 7b formed on the charge generating layer 8.

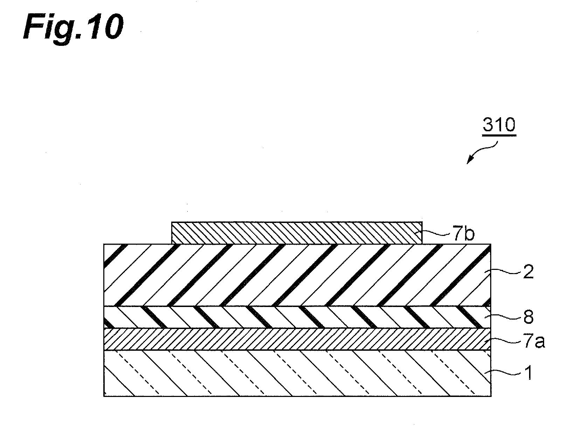

Figure 10 is a schematic sectional view of a photosensor according to a second embodiment. The photosensor 310 shown in Figure 10 comprises a substrate 1, a first electrode 7a formed on the substrate 1, a charge generating layer 8 formed on the first electrode 7a, an active layer 2 formed on the charge generating layer 8 and formed of the organic film containing the polymer according to the present invention, and a second electrode 7b formed on the active layer 2.

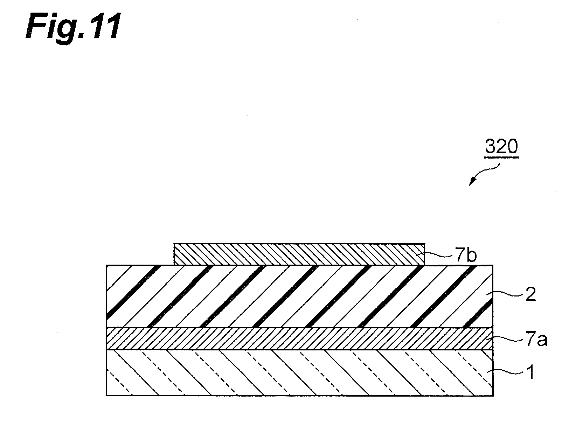

Figure 11 is a schematic sectional view of a photosensor according to a third embodiment. The photosensor 320 shown in Figure 11 comprises a substrate 1, a first electrode 7a formed on the substrate 1, an active layer 2 formed on the first electrode 7a and formed of the organic film containing the polymer according to the present invention, and a second electrode 7b formed on the active layer 2.

A transparent or semi-transparent electrode is used for one of the first electrode 7a and the second electrode 7b in the photosensors according to the first to third embodiments. The charge generating layer 8 is a layer that absorbs light and generates charges. As a material for the electrode, metals such as aluminum, gold, silver, copper, alkali metals, and alkaline earth metals, or semi-transparent films thereof, and transparent conductive films can be used. In order to increase photosensitivity in the active layer 2 (organic film), a carrier generating agent, a sensitizer, and the like can be added and used. Moreover, as the substrate 1, a silicon substrate, a glass substrate, a plastic substrate, and the like can be used.

As mentioned above, the present invention has been described in detail on the basis of the suitable embodiments, but the present invention will not be limited to the above embodiments. Various modifications can be made on the present invention without deviating from the gists thereof.

### Examples

Hereinafter, the present invention will be more specifically described on the basis of Examples and Comparative Examples, but the present invention will not be limited to the following Examples at all.

### (Measurement conditions and the like)

Ultraviolet visible absorption (UV) measurement was conducted using a trade name "Shimadzu UV-Visible spectrophotometer" (UV-3100PC) made by Shimadzu Corp. Fluorescence spectrum (PL) measurement was conducted using a trade name "Fluoromax-2 spectrometer" made by Horiba, Ltd. The measurement was conducted using a solution prepared by dissolving a proper amount of a sample in chloroform in each case. A band gap was determined by calculation from rise of ultraviolet and visible absorption spectrum. GPC measurement was conducted using a trade name "Hitachi UV/VIS detector (L-2400), and a Hitachi pump (L-2130)," made by Hitachi High-Technologies Corp., and "a TOSOH analyzing system (GPC-8200 model II ver. 6.0)" and using a trade name "Shodex column (L805)" as a column. The molecular weight of the sample was determined in terms of polystyrene conversion. The measurement was conducted using chloroform as a solvent at a flow rate of 1 mL per minute. A trade name "Silicagel 60N" (40 to 50 µm) made by Kanto Chemical Co., Inc. was used for silica gel in column chromatography separation. Moreover, a trade name "aluminum oxide 90 standardized" made by Merck KGaA was used for alumina. All the chemical substances were a reagent class, and were purchased from Wako Pure Chemical Industries, Ltd., Tokyo Chemical Industry Co., Ltd., Kanto Chemical Co., Inc., Nacalai Tesque, Inc., or Sigma-Aldrich Japan, Inc.

### [Example 1]

### <Synthesis of Compound A>

After 3,3'-dihexyl-bithiophene (1.24 g, 3.71 mmol) and tetrahydrofuran (THF) (30 mL) were placed into a 100-mL flask subjected to replacement by nitrogen, the temperature was reduced to 0°C. N-bromosuccinimide (NBS) (692 mg, 3.89 mmol) was added, and the reaction solution was stirred for 3 hours. Subsequently, water (2 mL) was added to the reaction solution to stop the reaction. The organic layer was washed twice using 20 mL of water, and subsequently dried with anhydrous magnesium sulfate. The organic layer was concentrate under reduced pressure, and subsequently refined with column chromatography (silica gel, hexane) to obtain Compound A (1.38 g, yield of 90%) represented by the following formula (13) as a yellow oil.

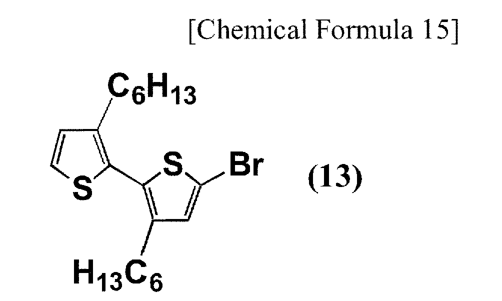

### <Synthesis of Compound B>

After anhydrous ether (5 mL) and phenylmagnesium bromide (788 mg, 4.35 mmol) were placed into a 50-mL three neck flask subjected to replacement by nitrogen, and nickel diphenyl phosphinopropane dichloride (8 mg, 0.0145 mmol) was placed into the flack, an ether solution (15 mL) of Compound A (0.6 g, 1.45 mmol) was dropped. After the temperature was raised to 50°C to perform the reaction for 3 hours, the temperature was returned to room temperature, distilled water was added to stop the reaction. Extraction with hexane (20 mL) was conducted, and the extracted organic layer was washed twice using 20 mL of water, and subsequently dried with anhydrous magnesium sulfate. The organic layer was concentrate under reduced pressure, and subsequently refined with column chromatography (silica gel, hexane) to obtain Compound B (0.48 g, yield of 80%) represented by the following formula (14) as a yellow oil.

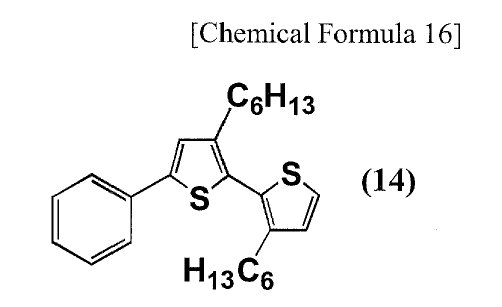

### <Synthesis of Compound C>

After Compound B (200 mg, 0.487 mmol) was placed into a 30-mL two-neck flask dried by heating and subjected to replacement by nitrogen, and dry THF (3 mL) was added, the temperature was reduced to -78°C, 1.6 M of n-butyllithium/hexane (0.6 mL, 0.97 mmol) was dropped. After stirring the reaction solution for 30 minutes, tributyltin chloride (0.4 mL, 1.46 mmol) was added at one time. The temperature of the reaction system was raised to room temperature, and after stirring the reaction solution for 3 hours, water (20 mL) and hexane (20 mL) were added to the reaction solution. The organic layer was washed twice using water (20 mL), and subsequently dried with anhydrous sodium sulfate. The organic layer was concentrate under reduced pressure, and subsequently refined with column chromatography (alumina, hexane) to obtain Compound C (276 mg, yield of 81%) represented by the following formula (15) as a yellow oil.

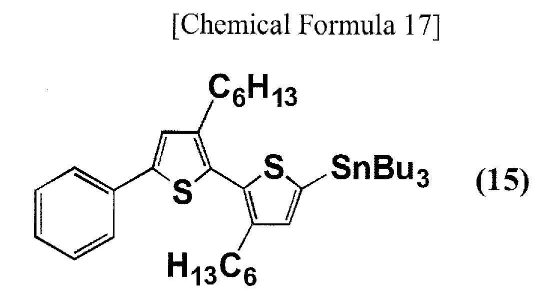

### <Synthesis of Compound D>

Compound C (98 mg, 0.14 mmol) and 3,5-dibromoiodobenzene (76 mg, 0.21 mmol) were placed into a 30-mL flask subjected to replacement by nitrogen, and dry toluene (1mL) was added. After degassing, tetrakistriphenyl phosphinepalladium(0) (7 mg, 0.007 mmol) was added, and reflux under heating was performed for 12 hours. The organic layer was concentrate under reduced pressure, and subsequently refined with column chromatography (silica gel, and hexane/chloroform = 9/1) to obtain Compound D (62 mg, yield of 69%) represented by the following formula (16) as a yellow solid.

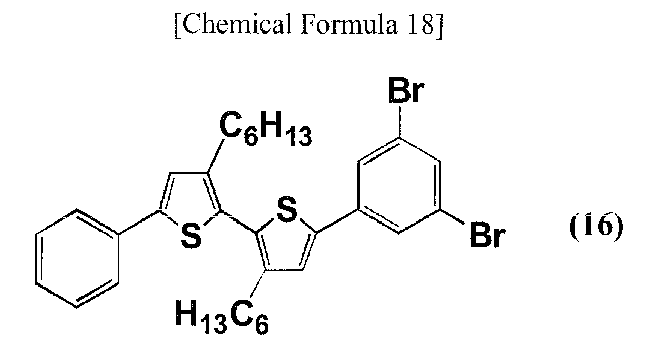

### <Synthesis of Compound E>

After 5,5"'-dibromo-3,3"'-dihexyl-quarter thiophene (230 mg, 0.35 mmol) was placed into a 30-mL two-neck flask dried by heating and subjected to replacement by nitrogen, and dry THF (3 mL) was added, the temperature was reduced to -78°C, and 1.6 M of n-butyllithium/hexane (0.66 mL, 1.05 mmol) was dropped. After stirring the reaction solution for 30 minutes, tributyltin chloride (0.25 mL, 1.4 mmol) was added at one time. After the temperature of the reaction system was raised to room temperature and the reaction solution was stirred for 3 hours, water (1 mL) and hexane (20 mL) were added to the reaction solution. The organic layer was washed twice using water (20 mL), and subsequently dried with anhydrous sodium sulfate. The organic layer was concentrate under reduced pressure, and subsequently refined with column chromatography (alumina, hexane) to obtain Compound E (360 mg, yield of 96%) represented by the following formula (17) as a yellow oil.

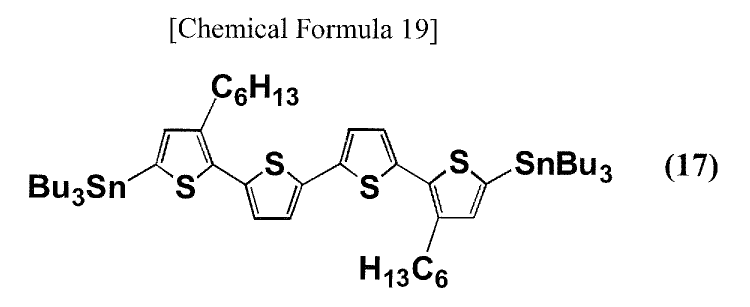

### <Synthesis of Polymer A>

After Compound E (46 mg, 0.043 mmol) and Compound D (27.5 mg, 0.043 mmol) were placed into a test tube with a screw cap subjected to replacement by nitrogen, dry toluene (0.5 mL) and tetrakistriphenyl phosphinepalladium(0) (4.4 mg, 0.43 µmol) were added under nitrogen gas flow, and the reaction solution was heated and stirred for three days. The thus-obtained reaction solution was filtered with a membrane filter, and concentrate under reduced pressure. Subsequently, the concentrate reaction solution was dissolved in a small amount of chloroform, poured into methanol, and precipitated. Subsequently, the precipitate was recovered by centrifugal separation, and underwent methanol washing and hexane washing, respectively. Thereby, Polymer A (28 mg, yield of 67%) represented by the following formula (18) was obtained as a red solid. In the formula (18), g is not less than two. The terminal group of Polymer A is a hydrogen atom or a bromine atom.

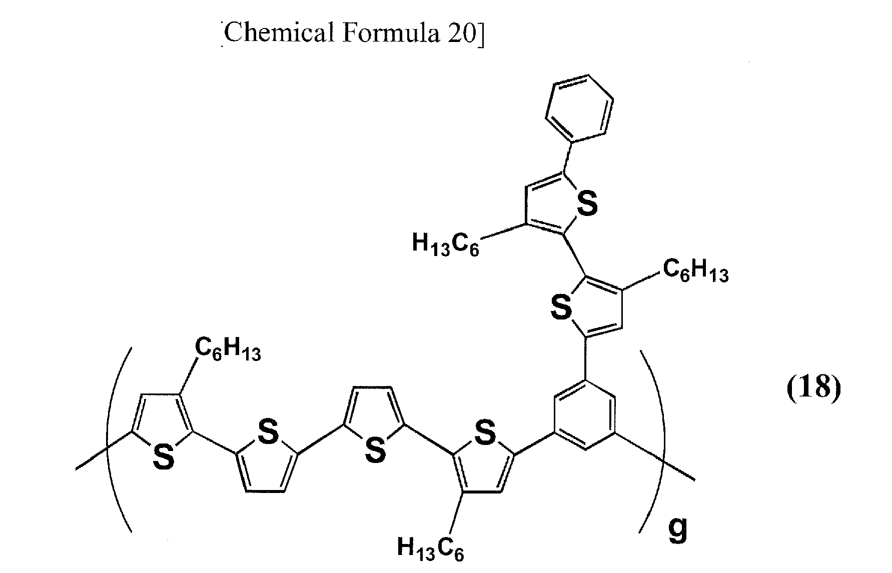

### [Example 2]

### <Synthesis of Compound I>

After 3,3"'-dihexyl-quarter thiophene (1.37 g, 2.75 mmol) and THF (20 mL) were placed into a 100-mL flask subjected to replacement by nitrogen, the temperature was reduced to 0°C, NBS (514 mg, 2.88 mmol) was added, and the reaction solution was stirred for 3 hours. Subsequently, water (2 mL) was added to the reaction solution to stop the reaction. The organic layer was washed twice using 20 mL of water, and subsequently dried with anhydrous sodium sulfate. The organic layer was concentrate under reduced pressure, and subsequently refined with column chromatography (silica gel, hexane) to obtain Compound I (915 mg, yield of 57%) represented by the following formula (23) as a yellow oil.

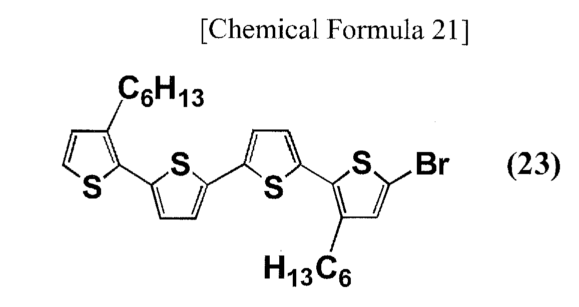

### <Synthesis of Compound F>

After anhydrous ether (5 mL) and phenylmagnesium bromide (658 mg, 3.63 mmol) were placed into a 50-mL three neck flask subjected to replacement by nitrogen and nickel diphenyl phosphinopropane dichloride (6.5 mg, 0.0121 mmol) was placed into the flask, an ether solution (15 mL) of Compound I (0.7 g, 1.21 mmol) was dropped. The temperature was raised to 50°C, and the reaction was conducted for 3 hours. Subsequently, the temperature was returned to room temperature, and distilled water was added to stop the reaction. Extraction with hexane (20 mL) was conducted. The extracted organic layer was washed twice using 20 mL of water, and subsequently dried with anhydrous magnesium sulfate. The organic layer was concentrate under reduced pressure, and subsequently refined with column chromatography (silica gel, hexane) to obtain Compound F (0.6 g, yield of 87%) represented by the following formula (19) as a yellow oil.

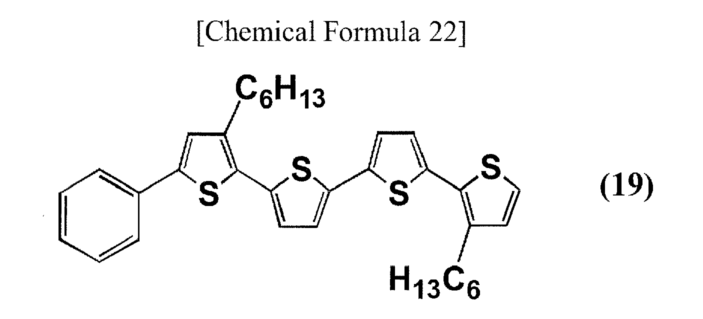

### <Synthesis of Compound G>

Compound F (150 mg, 0.26 mmol) was placed into a 50-mL two-neck flask dried by heating and subjected to replacement by nitrogen. After dry THF (3 mL) was added, the temperature was reduced to -78°C, and 1.6 M of n-butyllithium/hexane (0.3 mL, 0.52 mmol) was dropped. After stirring the reaction solution for 30 minutes, tributyltin chloride (0.14 mL, 0.78 mmol) was added at one time. After the temperature of the reaction system was raised to room temperature and the reaction solution was stirred for 3 hours, water (2 mL) was added to the reaction solution to extract an organic layer with hexane (20 mL). The organic layer was washed twice using water (20 mL), and subsequently dried with anhydrous sodium sulfate. The organic layer was concentrate under reduced pressure, and subsequently refined with column chromatography (alumina, hexane) to obtain Compound G (230 mg, yield of 100%) represented by the following formula (20) as a yellow oil.

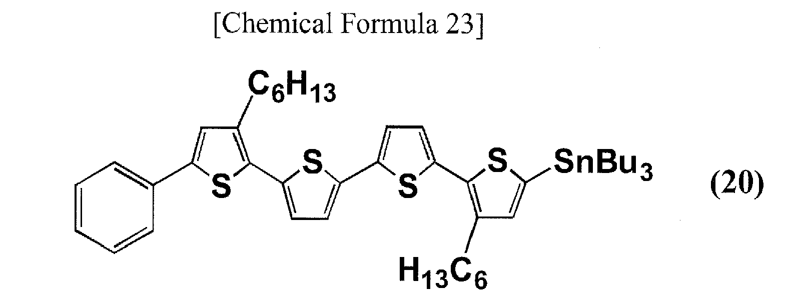

### <Synthesis of Compound H>

After Compound G (100 mg, 0.116 mmol) and 3,5-dibromo iodobenzene (63 mg, 0.174 mmol) were placed into a 50-mL two-neck flask subjected to replacement by nitrogen, dry toluene (1 mL) was added. After degassing, tetrakistriphenyl phosphinepalladium(0) (6 mg, 0.0059 mmol) was added, and reflux under heating was performed for 12 hours. The organic layer was concentrate under reduced pressure, and subsequently refined with column chromatography (silica gel, hexane/chloroform = 9/1) to obtain Compound H (81 mg, yield of 87%) represented by the following formula (21) as a yellow-red solid.

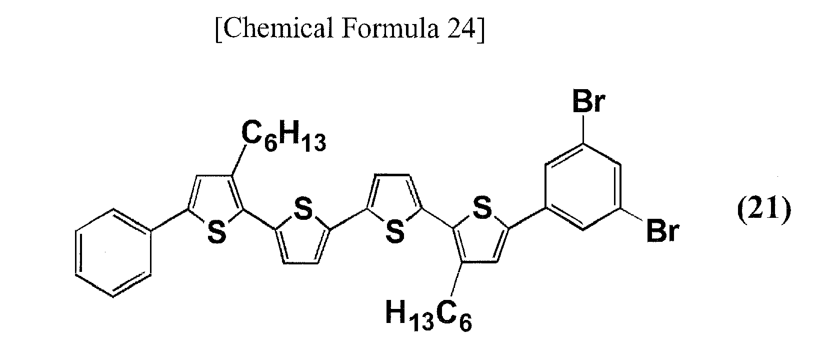

### <Synthesis of Polymer B>

After Compound E (111.7 mg, 0.103 mmol) and Compound H (84 mg, 0.103 mmol) were placed into a test tube with a screw cap subjected to replacement by nitrogen, dry toluene (0.4 mL) and tetrakistriphenyl phosphinepalladium(0) (10.7 mg, 1.03 µmol) were added under nitrogen gas flow, and the reaction solution was heated and stirred for three days. The thus-obtained reaction solution was filtered with a membrane filter, and concentrate under reduced pressure. Subsequently, the concentrate reaction solution was dissolved in a small amount of chloroform, poured into methanol, and precipitated. Subsequently, the precipitate was recovered by centrifugal separation, and underwent methanol washing and hexane washing, respectively. Thereby, Polymer B (97 mg, yield of 81 %) represented by the following formula (22) was obtained as a reddish brown solid. In the formula (22), g is not less than two. The terminal group of Polymer B is a hydrogen atom or a bromine atom.

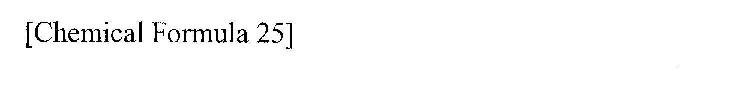

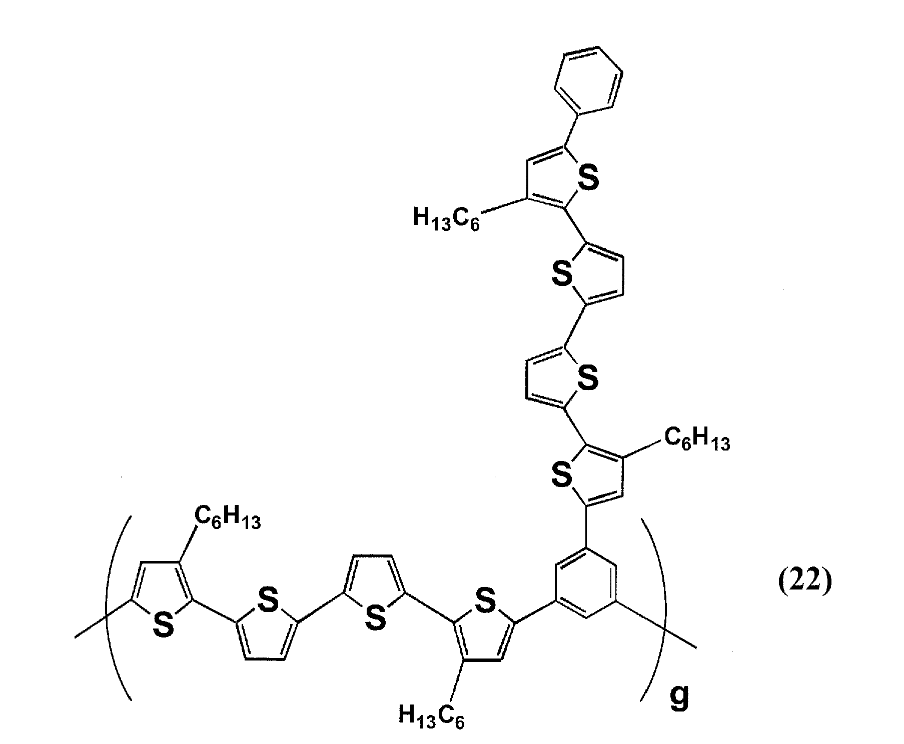

### [Example 3]

### <Synthesis of Compound J>

After Compound G (300 mg, 0.347 mmoL) and Compound I (300 mg, 0.52 mmol) were placed into a 30-mL flask subjected to replacement by nitrogen, dry toluene (5 mL) was added. After degassing, tetrakistriphenyl phosphinepalladium(0) (18 mg, 0.017 mmol) was added, and reflux under heating was performed for 12 hours. Subsequently, the reaction was stopped, and the obtained organic layer was concentrate under reduced pressure. Then, the concentrate organic layer was refined with column chromatography (silica gel, hexane) to obtain Compound J (301 mg, yield of 81%) represented by the following formula (24) as a red oil.

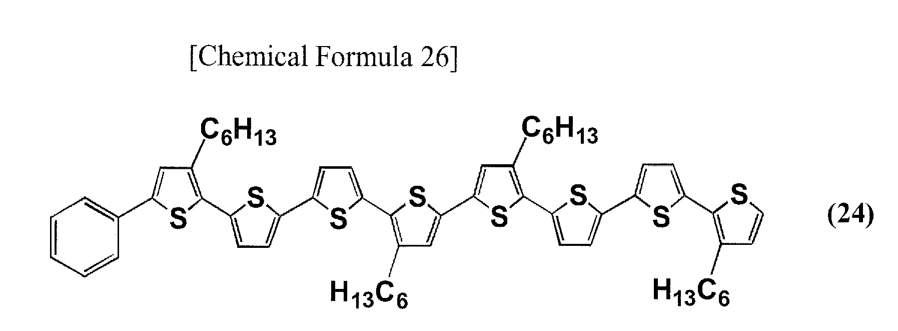

### <Synthesis of Compound K>

After Compound J (131 mg, 0.123 mmol) was placed into a 30-mL two-neck flask dried by heating and subjected to replacement by nitrogen and dry THF (14 mL) was added, the temperature was reduced to -78°C, and 1.6 M of n-butyllithium/hexane (0.23 mL, 0.37 mmol) was dropped. After stirring the reaction solution for 30 minutes, tributyltin chloride (0.13 mL, 0.49 mmol) was added at one time. The temperature of the reaction system was raised to room temperature, and the reaction solution was stirred for 3 hours. Subsequently, water (20 mL) and hexane (20 mL) were added to the reaction solution. The organic layer was washed twice using water (20 mL), and then, Compound K (155 mg, yield of 93%) represented by the following formula (25) was obtained as a yellow oil.

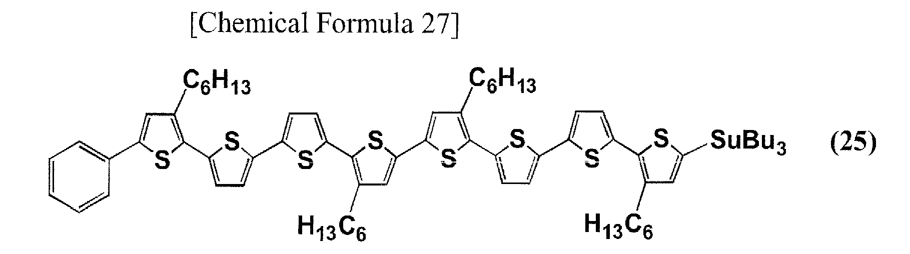

### <Synthesis of Compound L>

After Compound K (155 mg, 114 mmol) and 3,5-dibromo iodobenzene (66 mg, 0.185 mmol) were placed into a 30-mL flask subjected to replacement by nitrogen, dry toluene (3 mL) was added. After degassing, tetrakistriphenyl phosphinepalladium(0) (6 mg, 0.006 mmol) was added, and reflux under heating was performed for 12 hours. Subsequently, the reaction was stopped, and the obtained organic layer was concentrate under reduced pressure. Subsequently, the concentrate organic layer was refined with column chromatography (silica gel, hexane). Thereby, Compound L (88 mg, yield of 55%, two stages) represented by the following formula (26) was obtained as a yellow solid.

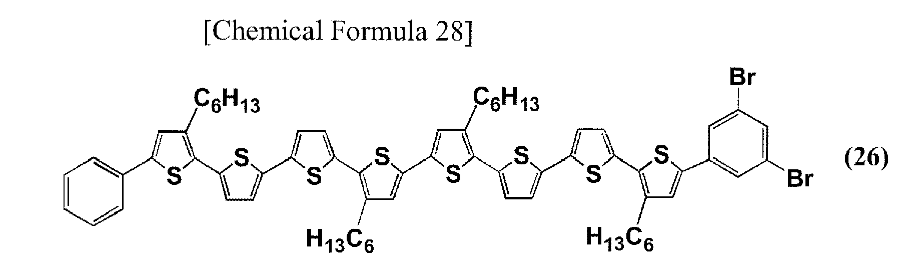

### <Synthesis of Polymer C>

After Compound E (29.4 mg, 0.027 mmol) and Compound L (35.7 mg, 0.027 mmol) were placed into a test tube with a screw cap subjected to replacement by nitrogen, dry toluene (0.7 mL) and tetrakistriphenyl phosphinepalladium(0) (2.8 mg, 0.27 µmol) were added under nitrogen gas flow, and the reaction solution was heated and stirred for three days. The thus-obtained reaction solution was filtered with a membrane filter, and concentrate under reduced pressure. Subsequently, the concentrate reaction solution was dissolved in a small amount of chloroform, poured into methanol, and precipitated. Subsequently, the precipitate was recovered by centrifugal separation, and underwent methanol washing and hexane washing, respectively. Thereby, Polymer C (30 mg, yield of 67%) represented by the following formula (27) was obtained as a red black solid. In the formula (27), g is not less than two. The terminal group of Polymer C is a hydrogen atom or a bromine atom.

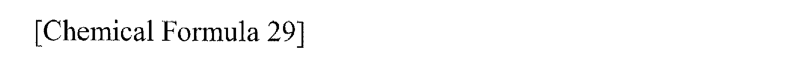

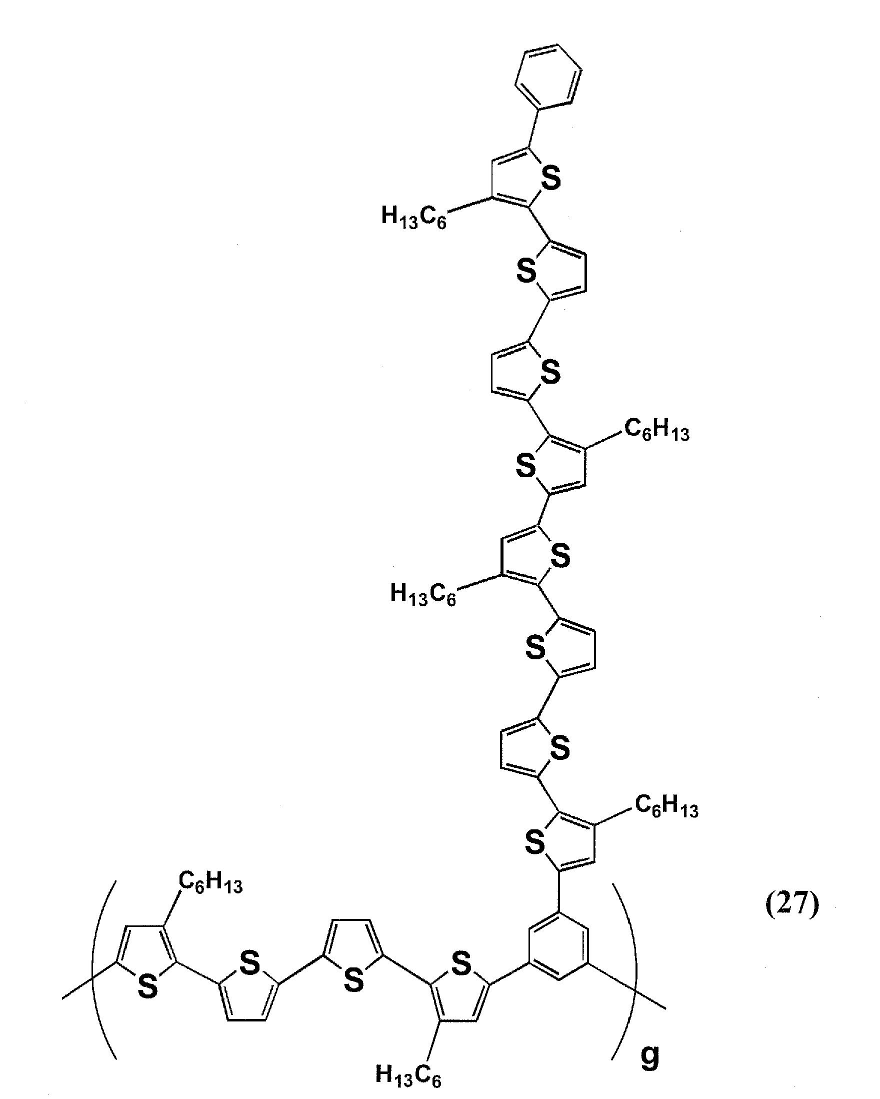

### [Comparative Example 1]

### <Synthesis of Polymer D>

After Compound E (111.3 mg, 0.103 mmol) and 1,3-dibromo benzene (24.4 mg, 0.103 mmol) were placed into a test tube with a screw cap subjected to replacement by nitrogen, dry toluene (0.5 mL) and tetrakistriphenyl phosphinepalladium(0) (10.6 mg, 1.03 µmol) were added under nitrogen gas flow, and the reaction solution was heated and stirred for three days. The thus-obtained reaction solution was poured into methanol in the state where the reaction solution was dissolved in heated toluene, and precipitated. Subsequently, the precipitate was recovered by centrifugal separation, and underwent methanol washing and hexane washing, respectively. Thereby, Polymer D (42 mg, yield of 71%) represented by the following formula (28) was obtained as a red solid. In the formula (28), g is not less than two. The terminal group of Polymer D is a hydrogen atom or a bromine atom.

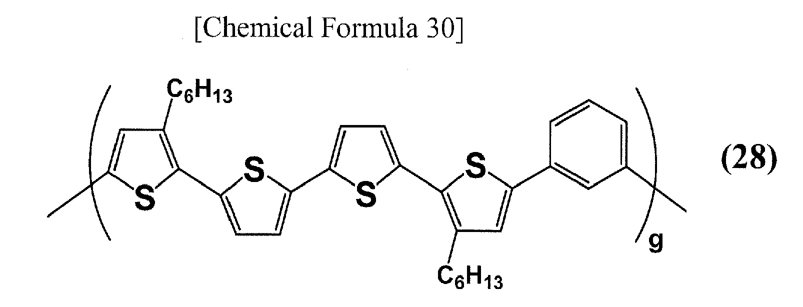

### [Analysis of the polymer]

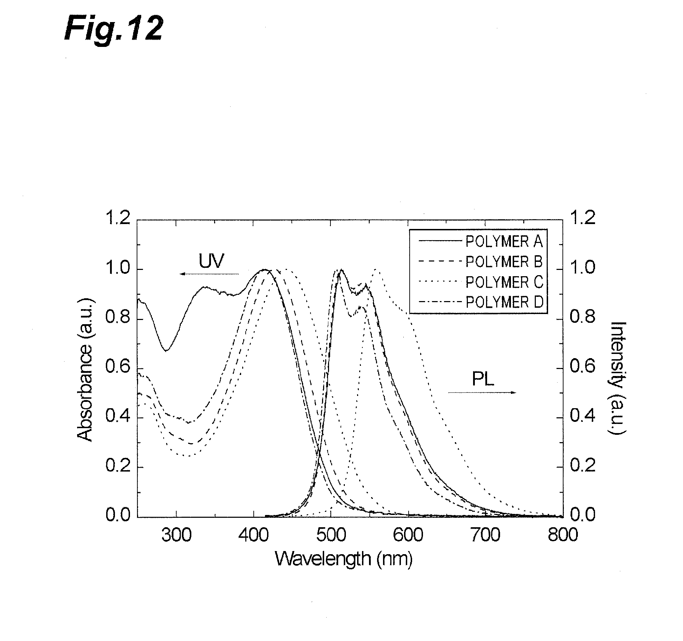

Ultraviolet visible absorption (UV) measurement, fluorescence spectrum (PL) measurement, and GPC measurement of Polymers A to D synthesized in Examples 1 to 3 and Comparative Example 1 were conducted. Moreover, solubility in chloroform of Polymers A to D was evaluated, and the shape of the thin film formed using the chloroform solution was further observed. The shape of the thin film is good in the case where the thin film is in a uniform film state, and poor in the case where the thin film is in a non-uniform film state. The following table shows those results. Moreover, Figure 12 shows ultraviolet and visible absorption spectrum and fluorescence spectrum of Polymers A to D.

**[Table 4]**

| | UV λ max (nm) | PL λ max (nm) | Band Gap (eV) | Mw | Mw/Mn | Solubility | Shape of thin film |
|---|---|---|---|---|---|---|---|
| Example 1 (Polymer A) | 413 | 513 | 2.18 | 20500 | 1.75 | Soluble | Uniform film state |
| Example 2 (Polymer B) | 428 | 513 | 2.18 | 11500 | 1.65 | Soluble | Uniform film state |
| Example 3 (Polymer C) | 442 | 557 | 2.04 | 19500 | 1.67 | Soluble | Uniform film state |
| Comparative Example 1 (Polymer D) | 416 | 508 | 2.18 | 21700 | 1.78 | Hardly soluble | Non-uniform film state |

### [Example 4]

### <Production of Organic Film Transistor 1, and evaluation of properties of the organic film transistor>

A silicon wafer, in which a comb-shaped source electrode and drain electrode (Cr (3 nm)/Au (50 nm), channel length/channel width = 5 µm/295 mm) were formed on a thermal oxide film (silicon oxide film, a film thickness of 300 nm), was immersed in each of ethanol, distilled water, and acetone in this order, and was subjected to ultrasonic cleaning for 30 minutes for each case. Subsequently, this silicon wafer was subjected to UV-ozone washing to obtain a substrate whose surface was hydrophilic. This substrate was immersed in hexamethyldisilazane:chloroform (volume ratio of 1:9) at room temperature for 1 hour, and subjected to ultrasonic cleaning with chloroform to obtain a substrate subjected to a surface treatment.

Next, Polymer C synthesized in Example 3 was adjusted so as to have a concentration of 0.5% by mass, added to chloroform, and stirred at room temperature to be dissolved completely. Thus, a coating solution of Polymer C was prepared. Using this coating solution, a film was formed with spin coating (1500 rpm) to form an organic film on the substrate subjected to the surface treatment, and thus, Organic Film Transistor 1 was produced.

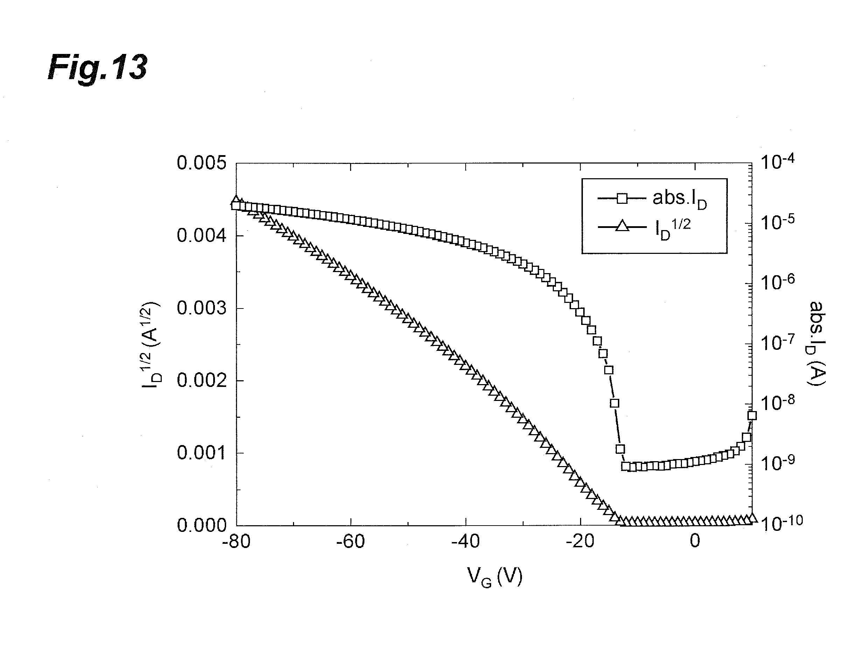

Obtained Organic Film Transistor 1 was annealed in vacuum at 150°C for 5 minutes. Subsequently, the properties of the organic transistor were measured by using a semiconductor parameter analyzer (a trade name "4200-SCS," made by Keithley Instruments, Inc.), and changing a gate voltage Vg in the range of 0 to -80 V and a voltage Vsd between a source and a drain in the range of 0 to -80 V, and then, good Id-Vg properties of a p-type semiconductor were obtained. Figure 13 shows the measurement result of the Id-Vg properties of Organic Film Transistor 1. Moreover, the field effect mobility at Vsd = -80 V was 1.2 × 10⁻⁴ cm²/Vs, the threshold voltage Vt = -13 V, and the On/Off ratio = 1 × 10⁴.

### [Example 5]

### <Production of Organic Film Transistor 2, and evaluation of the properties of the organic film transistor>

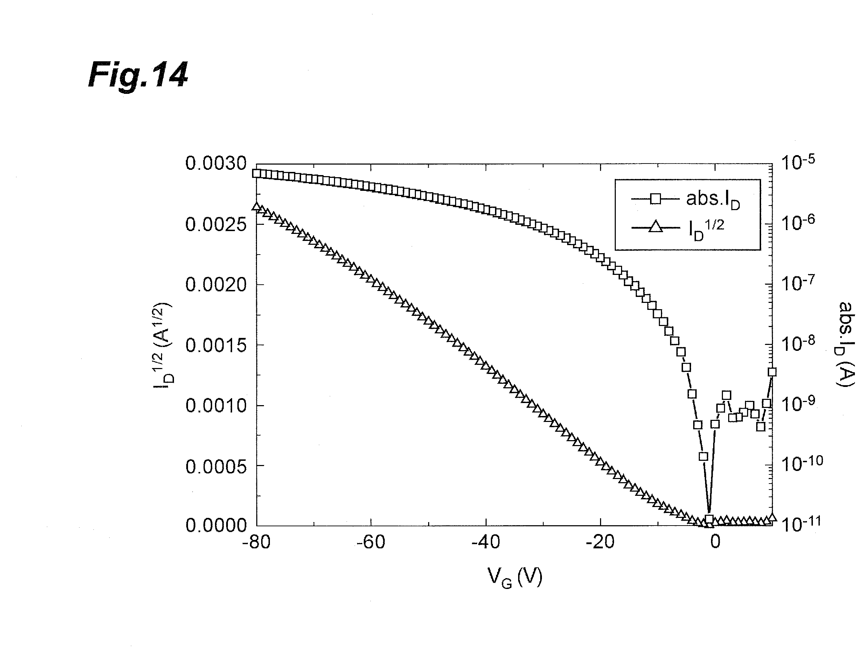

A coating solution of Polymer B was prepared with the same method as that in Example 4 except that Polymer B synthesized in Example 2 was used instead of Polymer C. At the time of preparation of this coating solution, Polymer B was dissolved in chloroform completely at room temperature. Using this solution, Organic Film Transistor 2 was produced in the same method as that in Example 4. About Organic Film Transistor 2, the properties of the organic transistor were measured with the same method as that in Example 4, and then, good Id-Vg properties of a p-type semiconductor were obtained. Figure 14 shows the measurement result of the Id-Vg properties of Organic Film Transistor 2. Moreover, the field effect mobility at Vsd = -80 V was 3 × 10⁻⁵ cm²/Vs, the threshold voltage Vt = -7 V, and the On/Off ratio = 1 × 10⁵.

### [Comparative Example 2]

### <Production of Organic Film Transistor 3, and evaluation of the properties of the organic film transistor>

Polymer D synthesized in Comparative Example 1 was adjusted so as to have a concentration of 0.5% by mass, added to chloroform and stirred at room temperature. Polymer D was not dissolved, and a suspension was obtained. Next, this suspension was heated to a temperature near the boiling point of chloroform, and stirred, but Polymer D could not be completely dissolved. Using toluene instead of chloroform, Polymer D was adjusted so as to have a concentration of 0.5% by mass, added to toluene, and heated to a temperature near the boiling point of toluene. Thereby, Polymer D was dissolved completely, but when the obtained solution was cooled, the polymer was deposited.

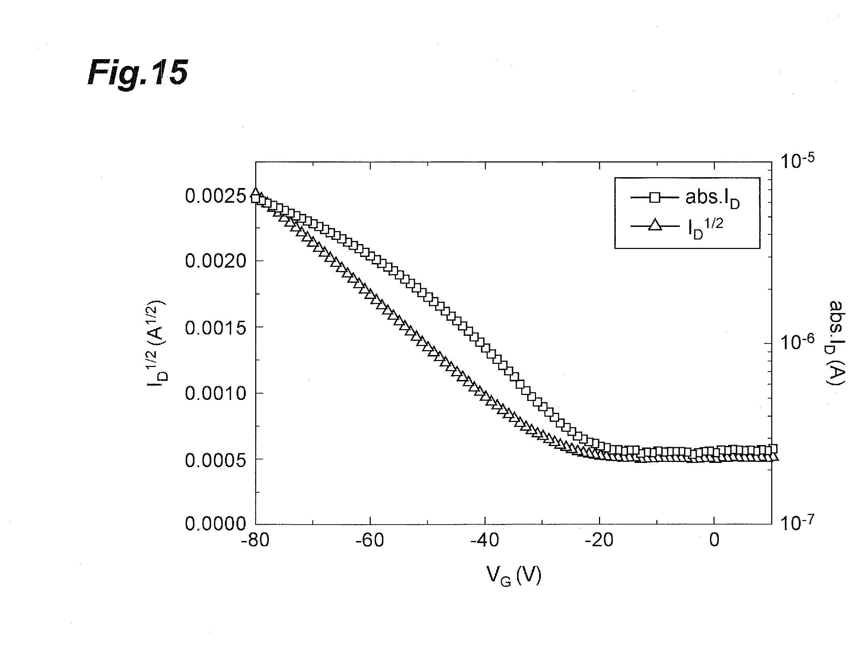

The toluene solution obtained by heating and dissolving Polymer D was dropped onto the same substrate subjected to the surface treatment as that used in Example 4. Subsequently, a film was quickly formed with a spin coating method (1500 rpm) to produce Organic Film Transistor 3. About Organic Film Transistor 3, the properties of the organic transistor were measured with the same method as that in Example 4, and then, the Id-Vg properties of a p-type semiconductor were obtained, but the Id-Vg properties were lower than those in Examples 4 and 5. Figure 15 shows the measurement result of the Id-Vg properties of Organic Film Transistor 3. Moreover, the field effect mobility at Vsd = -80 V was 3 × 10⁻⁵ cm²/Vs, the threshold voltage Vt = -15 V, and the On/Off ratio = 25.

### Industrial Applicability

As described above, according to the present invention, a novel polymer that has high charge transport property and solubility in a solvent, can be formed into an approximately uniform film, and can be used as an organic p-type semiconductor can be provided. Moreover, according to the present invention, an organic film containing this polymer and an organic film device comprising this organic film can be provided.

## Claims

1. A polymer comprising
a repeating structure represented by the following formula (1), wherein L and X each independently have a configuration in which are linked a plurality of conjugation forming structures each conjugated by itself, and each have
at least one thienylene structure as the conjugation forming structure: 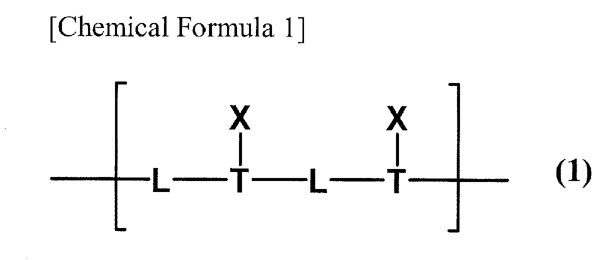 wherein each X represents a monovalent organic group that may have a substituent, each L represents a divalent organic group that may have a substituent, and each T represents a trivalent organic group that may have a substituent, with the proviso that in the formula, the X's represent the same group, the L's represent the same group, and the T's represent the same group.

2. The polymer according to claim 1, wherein the X's, the L's, and the T's are in conjugation as a whole.

3. The polymer according to claim 1 or 2, wherein each L is a divalent organic group represented by the following formula (2): 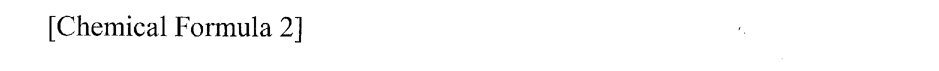 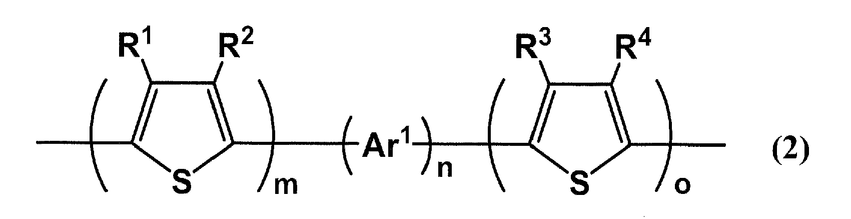 wherein Ar¹ represents a divalent aromatic hydrocarbon group that may have a substituent or a divalent heterocyclic group that may have a substituent; R¹, R², R³, and R⁴ each independently represent a hydrogen atom, an alkyl group, an alkoxy group, an aryl group that may have a substituent, or a monovalent heterocyclic group that may have a substituent, and part or all of hydrogen atoms in each of these groups may be replaced by a fluorine atom; when there are a plurality of R¹'s, a plurality of R²'s, a plurality of R³'s, and a plurality of R⁴'s, the R¹'s may be the same as or different from each other, the R²'s may be the same as or different from each other, the R³'s may be the same as or different from each other, and the R⁴'s may be the same as or different from each other; and further, m, n, and o each independently represent an integer of 0 to 10, with the proviso that at least one of m and o is an integer of not less than one, and m + n + o is an integer of 2 to 20.

4. The polymer according to any one of claims 1 to 3, wherein each T is one of trivalent organic groups represented by the following formulas (3) to (7): 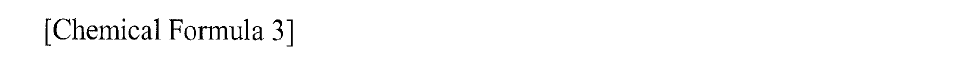 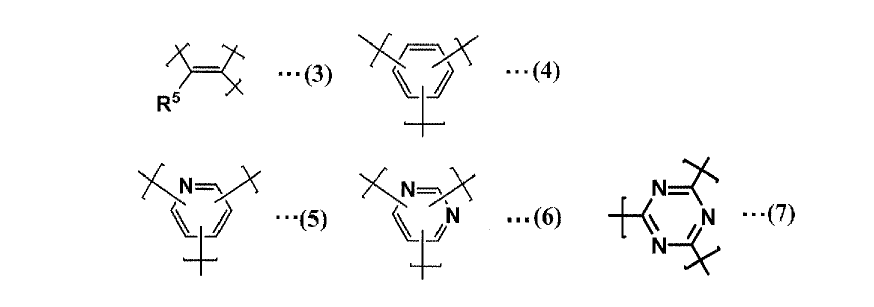 wherein R⁵ represents a hydrogen atom, an alkyl group, an aryl group, or a cyano group.

5. The polymer according to any one of claims 1 to 4, wherein each X is a monovalent organic group represented by the following formula (8): 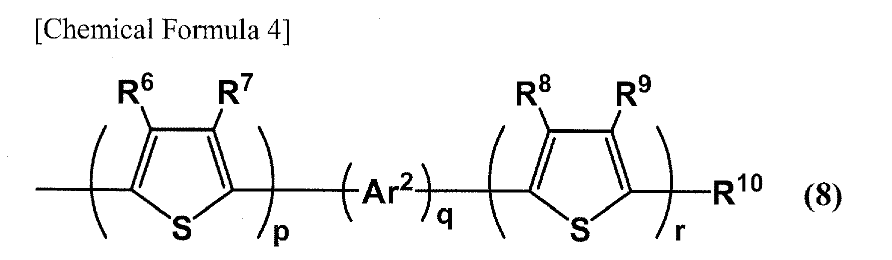 wherein Ar² represents a divalent aromatic hydrocarbon group that may have a substituent or a divalent heterocyclic group that may have a substituent; R⁶, R⁷, R⁸, and R⁹ each independently represent a hydrogen atom, an alkyl group, an alkoxy group, an aryl group that may have a substituent, or a monovalent heterocyclic group that may have a substituent, and part or all of hydrogen atoms in each of these groups may be replaced by a fluorine atom; when there are a plurality of R⁶'s, a plurality of R⁷'s, a plurality of R⁸'s, and a plurality of R⁹'s, the R⁶'s may be the same as or different from each other, the R⁷'s may be the same as or different from each other, the R⁸'s may be the same as or different from each other, and the R⁹'s may be the same as or different from each other; R¹⁰ represents a hydrogen atom or a monovalent group that may have a substituent; further, p, q, and r each independently represent an integer of 0 to 10, with the proviso that at least one of p and r is an integer of not less than one, and p + q + r is an integer of 2 to 20.

6. The polymer according to any one of claims 1 to 5, wherein the repeating structure represented by the formula (1) is a repeating structure represented by the following formula (9): 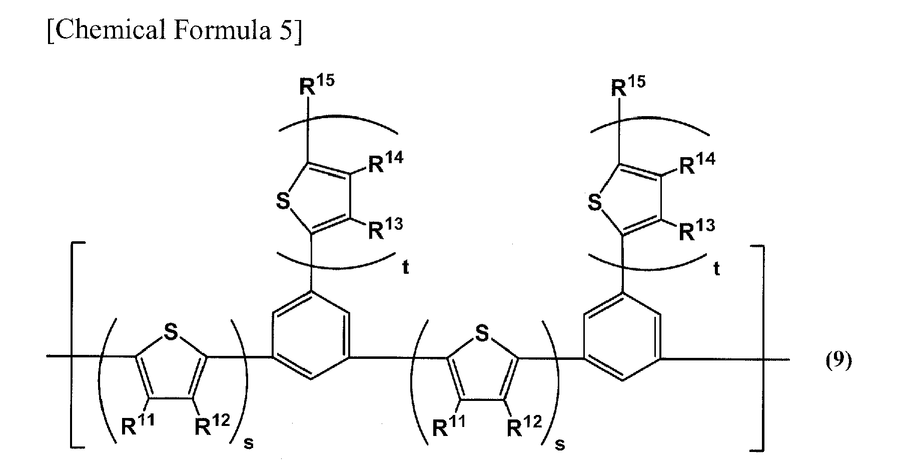 wherein R¹¹, R¹², R¹³, and R¹⁴ each independently represent a hydrogen atom, an alkyl group, an alkoxy group, an aryl group that may have a substituent, or a monovalent heterocyclic group that may have a substituent, and part or all of hydrogen atoms in each of these groups may be replaced by a fluorine atom; when there are a plurality of R¹¹'s, a plurality of R¹²'s, a plurality of R¹³'s, and a plurality of R¹⁴'s, the R¹¹'s may be the same as or different from each other, the R¹²'s may be the same as or different from each other, the R¹³'s may be the same as or different from each other, and the R¹⁴'s may be the same as or different from each other; R¹⁵ represents a hydrogen atom or a monovalent group that may have a substituent; s and t each independently represent an integer of 2 to 12, with the proviso that in the formula, the R¹¹'s represent the same group, the R¹²'s represent the same group, the R¹³'s represent the same group, the R¹⁴'s represent the same group, and the R¹⁵'s represent the same group; and s's and t's in the formula respectively represent the same integer.

7. The polymer according to any one of claims 1 to 6 comprising at least one repeating structures represented by the formula (1) and at least one repeating structures represented by the following formula (10): 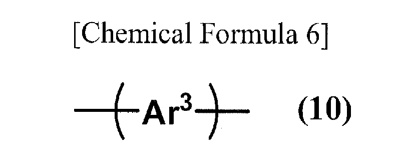 wherein Ar³ represents a divalent aromatic hydrocarbon group that may have a substituent or a divalent heterocyclic group that may have a substituent.

8. An organic film comprising the polymer according to any one of claims 1 to 7.

9. An organic film device comprising the organic film according to claim 8.

10. An organic film transistor comprising the organic film according to claim 8.
